(19) Europäisches Patentamt
European Patent Office
Office européen des brevets

(11) **EP 4 418 055 A1**

(12) **EUROPEAN PATENT APPLICATION**

(43) Date of publication:
**21.08.2024 Bulletin 2024/34**

(21) Application number: **24156918.5**

(22) Date of filing: **09.02.2024**

(51) International Patent Classification (IPC):
**G05B 13/02** (2006.01)     **G05B 19/418** (2006.01)

(52) Cooperative Patent Classification (CPC):
**G05B 19/41875; G05B 13/027;** G05B 2219/32193;
G05B 2219/32194; G05B 2219/45031

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.02.2023 US 202363484810 P**

(71) Applicant: **Gauss Labs Inc.
Palo Alto, CA 94301 (US)**

(72) Inventors:
• **JO, Pil Sung
Seoul (KR)**

• **PARK, Chan
Seoul (KR)**
• **ZABROCKI, Simon
Seoul (KR)**
• **LEE, Byung-Jun
Seoul (KR)**
• **JUNG, Minju
Palo Alto (US)**
• **YUN, Sunghee
Palo Alto (US)**
• **YIM, Dongkyun
Seoul (KR)**

(74) Representative: **Carpmaels & Ransford LLP
One Southampton Row
London WC1B 5HA (GB)**

(54) **SYSTEMS AND METHODS FOR PROCESS MONITORING AND CONTROL**

(57) Described are systems and methods for advanced process control and monitoring. Systems and methods may be associated with a data processing module configured to receive and process a plurality of data types and datasets from a plurality of different sources for generating training data; a training and optimization module configured to provide the training data to a machine learning pipeline for training and optimizing a model; and an inference module configured to use the model for generating one or more predicted metrics substantially in real-time, wherein the one or more predicted metrics are useable to characterize an output of a process performed by a process equipment.

FIG. 1

EP 4 418 055 A1

**Description**

## BACKGROUND

Some virtual metrology systems and methods can model processes and characteristics related to monitoring and control of manufacturing processes, e.g., processing of wafers in the semiconductor industry. Statistically modeling processes and characteristics may use, in part, current data or historical data, e.g., measurements from contemporary sensor data or historical sensor data. Virtual metrology systems and methods may provide more accurate measurements to, for example, control manufacturing processes. Virtual metrology systems and methods may, for example, increase productivity, improve quality, or lower maintenance costs when compared to physical inspections of manufacturing processes using traditional metrology. For example, virtual metrology systems and methods may be able to sample all or substantially all units (e.g., semiconductor wafers) in a manufacturing process whereas human operators using traditional metrology may be able to sample only a small fraction of units. Virtual metrology systems and methods may use, in part, machine learning methods to predict process variables or target properties associated with manufacturing processes.

## SUMMARY

Disclosed herein are systems and methods for continuous deployment in advanced process control and monitoring. Systems and methods can improve prediction performance of process variables or target properties.

In an aspect, disclosed are systems and methods for process monitoring and control. Systems may include, for example, a data processing module configured to receive and process a plurality of data types and datasets from a plurality of different sources for generating training data; a training and optimization module configured to provide the training data to a machine learning pipeline for training and optimizing a model; and an inference module configured to use the model for generating one or more predicted metrics substantially in real-time, wherein the one or more predicted metrics are useable to characterize an output of a process performed by a process equipment.

In some embodiments, the inference module is configured to receive and provide process data to the model for generating the one or more predicted metrics, wherein the process data is received from the process equipment substantially in real-time as the process is performed.

In some embodiments, the inference module is configured to provide the one or more predicted metrics for the process control, or for process monitoring, improvement or trouble-shooting.

In some embodiments, the system further comprises a process control module configured to use the one or more predicted metrics to detect a drift, a shift, or a deviation in the process or the process equipment.

In some embodiments, the process control module is configured to use the one or more predicted metrics to correct or mitigate the drift, the shift, or the deviation in the process or the process equipment.

In some embodiments, the process control module is configured to use the one or more predicted metrics to improve process productivity via integration with run-to-run control.

In some embodiments, the model comprises a virtual metrology (VM) model.

In some embodiments, the system further comprises the process equipment, wherein said process equipment comprises a semiconductor process equipment.

In some embodiments, the output of the process comprises a deposited or fabricated structure.

In some embodiments, the deposited or fabricated structure comprises a film, a layer, or a substrate.

In some embodiments, the one or more predicted metrics comprise one or more dimensions or properties of the film, the layer, or the substrate.

In some embodiments, the system is configured to be used or deployed in a manufacturing environment.

In some embodiments, the plurality of data types and datasets comprise: (1) historical process data, (2) current process data, (3) historical measurement data of the one or more predicted metrics, (4) current measurement data of the one or more predicted metrics, (5) operation data, and/or (6) equipment specification data.

In some embodiments, the data processing module is configured to validate the historical process data and the historical measurement data against the operation data and the equipment specification data.

In some embodiments, the plurality of sources comprise a database that is configured to store at least the historical process data or the historical measurement data.

In some embodiments, the plurality of sources comprise a database or a log that is configured to store at least the operation data or the equipment specification data.

In some embodiments, the plurality of sources comprise the process equipment.

In some embodiments, the plurality of sources comprise a measurement equipment configured to collect the current measurement data.

In some embodiments, the data processing module is configured to receive and process the plurality of data types or datasets by generating a component hierarchical structure of the process equipment.

In some embodiments, the component hierarchical structure comprises a nested structure of (i) the process equipment and (ii) one or more components that are used within or in conjunction with the process equipment.

In some embodiments, the one or more components comprise one or more sub-equipment including chambers, stations, and/or sensors.

In some embodiments, the data processing module is configured to receive and process the plurality of data types or datasets by generating a step-operation hierarchical structure of a recipe for the process.

In some embodiments, the recipe comprises a plurality of steps, and wherein each step of the plurality of steps comprises a plurality of different sub-operations.

In some embodiments, the data processing module is configured to receive and process the plurality of data types or datasets by removing one or more data outliers.

In some embodiments, the data processing module is configured to pre-process and remove data outliers from the process data before the process data is input to the model in the inference module.

In some embodiments, the training data is continuously updated with the current process data and the current measurement data.

In some embodiments, the machine learning pipeline comprises two or more components from a plurality of components comprising of (i) feature engineering, (ii) time-aware data normalization, and/or (iii) an adaptive learning algorithm.

In some embodiments, the machine learning pipeline is configured to apply the training data through the two or more components sequentially or simultaneously.

In some embodiments, the feature engineering comprises an extraction of a plurality of features from raw trace data or sensor data within the training data.

In some embodiments, the feature engineering comprises use of an algorithm to select one or more features from a list of extracted features, based at least in part on local relationships between an input and an output of the model.

In some embodiments, the time-aware data normalization comprises a decomposition of time series data into one or more components including smoothing data, trend data, and/or detrend data.

In some embodiments, the time-aware data normalization is based on a model and a data type of the model.

In some embodiments, the adaptive learning algorithm is an adaptive online ensemble learning algorithm.

In some embodiments, the training and optimization module is configured to optimize the model using at least in part hyperparameter optimization.

In some embodiments, the training and optimization module is configured to (i) train the model with a given set of hyperparameters on an output from the machine learning pipeline.

In some embodiments, the training and optimization module is further configured to (ii) evaluate a performance of the model based on validation data.

In some embodiments, the validation data is split from the training data for the hyperparameter optimization.

In some embodiments, the training and optimization module is further configured to (iii) use a hyperparameter optimization algorithm to select a set of hyperparameters for a next iteration based on past performance, so as to increase or improve the performance of the model.

In some embodiments, the training and optimization module is further configured to repeat (i)-(iii) iteratively until the performance of the model meets termination criteria.

In another aspect, disclosed are methods for process monitoring and control. Methods may include, for example, (a) receiving and processing a plurality of data types and datasets from a plurality of different sources for generating training data; (b) providing the training data to a machine learning pipeline for training and optimizing a model; and (c) generating one or more predicted metrics substantially in real-time, wherein the one or more predicted metrics are useable to characterize an output of a process performed by a process equipment.

Additional aspects and advantages of the present disclosure will become readily apparent from the following detailed description, wherein only illustrative embodiments of the present disclosure are shown and described. As will be realized, the present disclosure is capable of other and different embodiments, and its several details are capable of modifications in various obvious respects, all without departing from the disclosure. Accordingly, the drawings and description are to be regarded as illustrative in nature, and not as restrictive.

## INCORPORATION BY REFERENCE

All publications, patents, and patent applications mentioned in this specification are herein incorporated by reference to the same extent as if each individual publication, patent, or patent application was specifically and individually indicated to be incorporated by reference. To the extent publications and patents or patent applications incorporated by reference contradict the disclosure contained in the specification, the specification is intended to supersede and/or take precedence over any such contradictory material.

## BRIEF DESCRIPTION OF THE DRAWINGS

The novel features of the disclosure are set forth with particularity in the appended claims. A better understanding of the features and advantages of the present disclosure will be obtained by reference to the following detailed description that sets forth illustrative embodiments, in which the principles of the disclosure are utilized, and the accompanying drawings of which:

**FIG. 1** illustrates a non-limiting example of systems for adaptive online time-series predictions of the present disclosure;

**FIG. 2** illustrates a non-limiting example of methods for adaptive online time-series predictions of the present disclosure;

**FIG. 3** illustrates a non-limiting example of advantages (e.g., sampling) of the present disclosure;

**FIGs. 4A-4B** illustrate non-limiting examples of equipment, processes, and process variables in semiconductor manufacturing processes of the present disclosure;

**FIG. 5** illustrates a non-limiting example of preparing data having hierarchical structures of the present disclosure;

**FIG. 6** illustrates a non-limiting example of extracting features from raw data and generating clean data of the present disclosure;

**FIG. 7** illustrates a non-limiting example of engineering features and training models of the present disclosure;

**FIG. 8** illustrates a non-limiting example of engineering features and training models of the present disclosure;

**FIG. 9** illustrates a non-limiting example of comparing methods (e.g., local versus global characterization methods) of the present disclosure;

**FIG. 10** illustrates a non-limiting example of local characterization methods (e.g., sliding window methods) of the present disclosure;

**FIGs. 11A-11D** illustrate a non-limiting example of time-aware normalization methods of the present disclosure. FIG. 11A illustrates a drifting feature and a response over time. FIG. 11B illustrates the drifting feature versus the response. FIG. 11C illustrates the time-aware normalized feature and response over time. FIG. 11D illustrates the time-aware normalized feature versus the response.

**FIG. 12** illustrates a non-limiting example of adaptive online learning methods of the present disclosure.

**FIGs. 13A-13C** illustrate a non-limiting example of prediction performance of the present disclosure. FIG. 13A illustrates a feature and a response over time. FIG. 13B illustrates the feature versus the response grouped by time range. At time 200, the relation between feature and response changes. FIG. 13C compares predictions over time on a shifting problem for the adaptive online learning model, online linear regressor model, and linear regressor model.

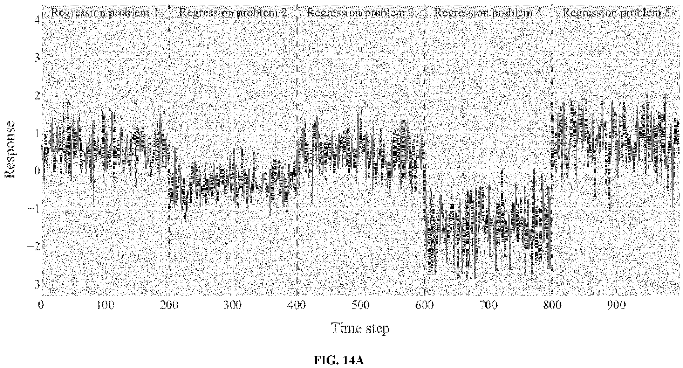

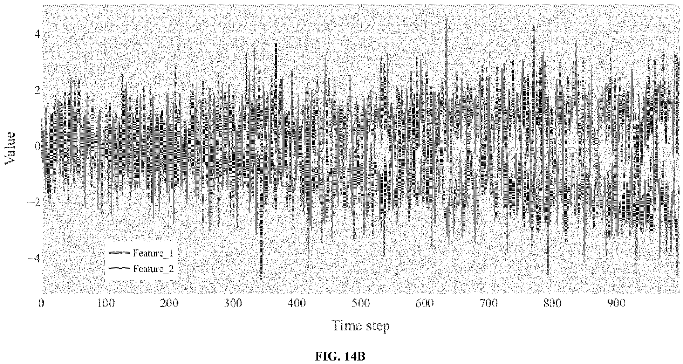

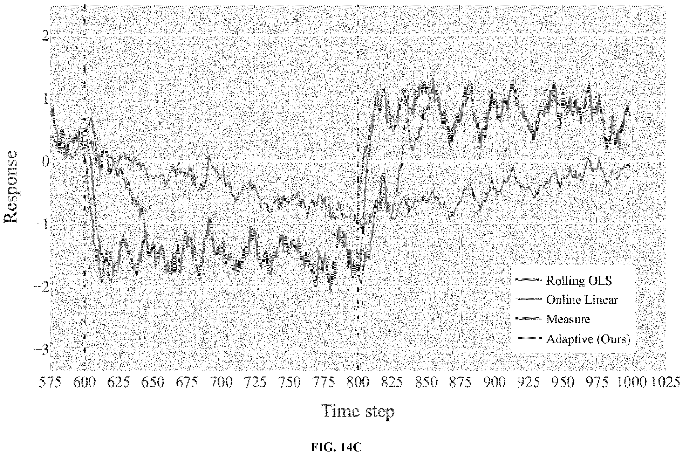

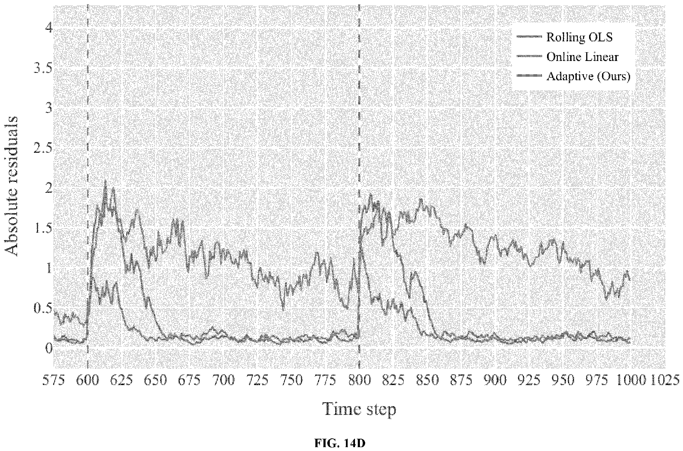

**FIGs. 14A-14D** illustrate a non-limiting example of prediction performance of the present disclosure using synthetic data. FIG. 14A illustrates the synthetic response versus time. Every 200 steps, the underlying model generating the response changes. FIG. 14B illustrates first and second features over time. Both synthetic features steadily drift away from their initial point. FIG. 14C illustrates predictions and measured response over time. At times 600 and 800, shifts occur. The adaptive methods described herein follow the measurements closely. The rolling OLS model struggles to adapt, and the online linear model does not adapt. FIG. 14D illustrates absolute residuals over time. The absolute residuals of the adaptive methods described herein quickly decrease. The residuals of the rolling OLS model are initially high but reach low levels, and the residuals of the online linear model remain high.

**FIGs. 15-16** illustrate non-limiting examples of graphical user interfaces (GUI) that can be configured to implement systems and methods of the present disclosure.

**FIG. 17** illustrates a non-limiting example of a computing device configured to perform systems and methods described herein;

**FIG. 18** illustrates a non-limiting example of a web or mobile application provision system configured to perform systems and methods described herein; and

**FIG. 19** illustrates a non-limiting example of a cloud-based web/mobile application provision system configured to perform systems and methods described herein.

## DETAILED DESCRIPTION

While various embodiments of the disclosure have been shown and described herein, such embodiments are provided by way of example only. Numerous variations, changes, or substitutions may occur without departing from the disclosure. It should be understood that various alternatives to the embodiments of the disclosure described herein may be employed.

Typical virtual metrology systems and methods are deficient for at least a few reasons. Some systems and methods may not be able to model data drifts, data shifts, or hierarchical data structures observed in manufacturing processes such as semiconductor manufacturing processes. Data drifts may generally refer to gradual changes of process dynamics due to, for example, aging of equipment used in manufacturing processes. Data shifts may generally refer to abrupt changes of process dynamics due to, for example, external operations such as maintenance or calibration. Advanced process control methods associated with virtual metrology methods may need accurate predictions of process variables or target properties in manufacturing processes. However, some methods may not be able to model non-stationarities observed in real or actual data, e.g., contemporary or historical sensor data. Non-stationarities can be generated in, for example, semiconductor manufacturing processes such as chemical vapor deposition (CVD), etching, diffusion, or other processes. For example, data drifts can cause steady or slow decreases in the accuracy of predictions associated with virtual metrology models. Data shifts can cause abrupt failures of virtual metrology models. Some virtual metrology methods using moving window-based methods can be inaccurate due to, for example, selecting small subsets of data. Some virtual metrology methods using just-in-time learning methods cannot adapt to changes in the underlying relationships between process variables or target properties.

Recognized herein is a need for better systems and methods for advanced process control and monitoring in manufacturing processes. Systems and methods disclosed herein can generate adaptive online time-series predictions for process variables or target properties in manufacturing processes.

## Systems and methods for process monitoring and control

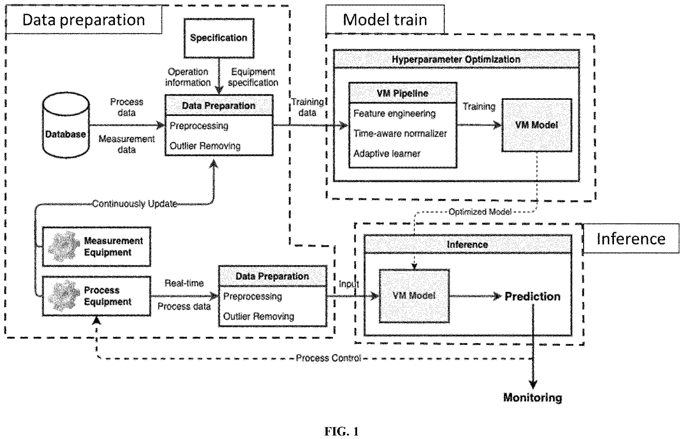

In an aspect, disclosed herein (FIG. 1) are systems for process monitoring and control. Systems may include, for example, a data processing module configured to receive and process a plurality of data types and datasets from a plurality of different sources for generating training data; a training and optimization module configured to provide the training data to a machine learning pipeline for training and optimizing a model; and an inference module configured to use the model for generating one or more predicted metrics substantially in real-time, wherein the one or more predicted metrics are useable to characterize an output of a process performed by a process equipment.

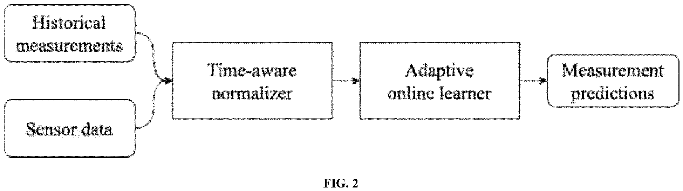

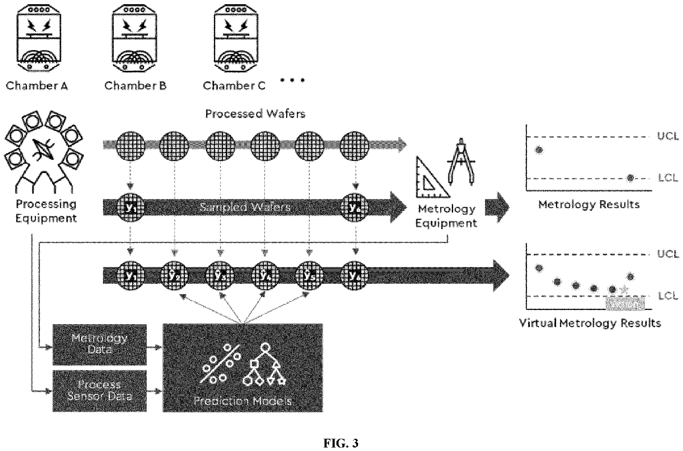

As shown in FIG. 2, systems may be associated with methods for advanced process control and monitoring in manufacturing processes. Methods described herein can generally include methods related to adaptive online time-series predictions of target properties or process variables. Target properties may include, for example, properties or characteristics of target products (e.g., film thickness or refractive index of wafers) determined through measurements from measurement tools or instruments. Process variables may include, for example, data generated from sensors associated with manufacturing processes or process equipment (e.g., temperature, power, or electrical current in chemical vapor deposition processes or equipment). Adaptive online time-series methods can generally include time-aware normalizer methods or adaptive online learner methods. As shown in FIG. 3, systems and methods described herein can be used in advanced process control and monitoring of manufacturing processes. Manufacturing processes can include semiconductor manufacturing processes associated with processing of semiconductor wafers. For example, processes can include chemical vapor deposition processes for semiconductor wafers.

### Applications

In some embodiments, the inference module is configured to receive and provide process data to the model for generating the one or more predicted metrics, wherein the process data is received from the process equipment substantially in real-time as the process is performed. In some cases, systems and methods disclosed herein may include virtual metrology systems and methods comprising one or more inference modules. In some embodiments, the model comprises a virtual metrology (VM) model. Virtual metrology models can be configured to predict metrics or properties associated with manufacturing processes. Metrics or properties may be related to process variables or target properties.

In some cases, metrics, properties, or characteristics may be associated with target properties or process variables in manufacturing processes of products. Target properties can include properties associated with products generated by equipment in manufacturing processes. For example, target properties may include a thickness or a refractive index of a film or a layer on a wafer or a substrate in chemical vapor deposition processes. Process variables can include variables associated with equipment configured to perform manufacturing processes. For example, process variables may include pressure, gas quantity, power, temperature, electrical current, and the like associated with equipment configured to perform chemical vapor deposition processes. Predictions of target properties or process variables may be based, in part, on measurement data, sensor data, sensor specification data, equipment data, equipment specification data, process data, or process specification data. Inference modules disclosed herein may generate predictions of target properties or process variables without physical measurements of target properties or process variables.

In some embodiments, the inference module is configured to provide the one or more predicted metrics for the process control, or for process monitoring, improvement or trouble-shooting. Manufacturing processes, such as semiconductor manufacturing processes, may use advanced process control systems and methods to control and monitor target properties or process variables (e.g., metrics). Advanced process control and monitoring methods can comprise methods for monitoring processes, controlling processes, improving processes, or trouble-shooting processes using feedback loops. Advanced process control systems and methods can include virtual metrology systems and methods. Virtual metrology systems and methods described herein may determine or predict target properties or process variables (e.g., outputs) and may provide predicted target properties or process variables (e.g., inputs) in feedback loops for advanced process control and monitoring.

In some embodiments, the system further comprises a process control module configured to use the one or more predicted metrics to detect a drift, a shift, or a deviation in the process or the process equipment. Metrics (e.g., data) from manufacturing processes (e.g., semiconductor processes) can differ significantly from other data due to, for example, continuously changing distribution of data. For example, data can include time series data with non-stationary characteristics. Non-stationary characteristics can comprise data drifts, data shifts, hierarchical data structures, or deviations in processes or equipment. Data drifts can cause steady or slow decreases in the accuracy of virtual metrology models. Data drifts can occur due to, for example, aging in equipment or sensors. Data shifts can cause abrupt failures of virtual metrology models. Data shifts can occur due to, for example, changes in equipment or sensor characteristics after maintenance or calibration. Data can have hierarchical structures associated with processes, equipment, stations, sensors, and the like. In some embodiments, the process control module is configured to use the one or more predicted metrics to correct or mitigate the drift, the shift, or the deviation in the process or the process equipment. Alternatively or additionally, the process control module can be configured to use the one or more predicted metrics to correct or mitigate deviations in processes or equipment.

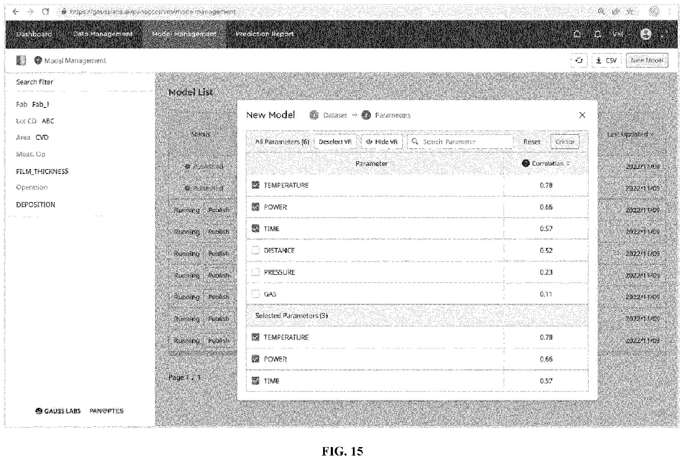

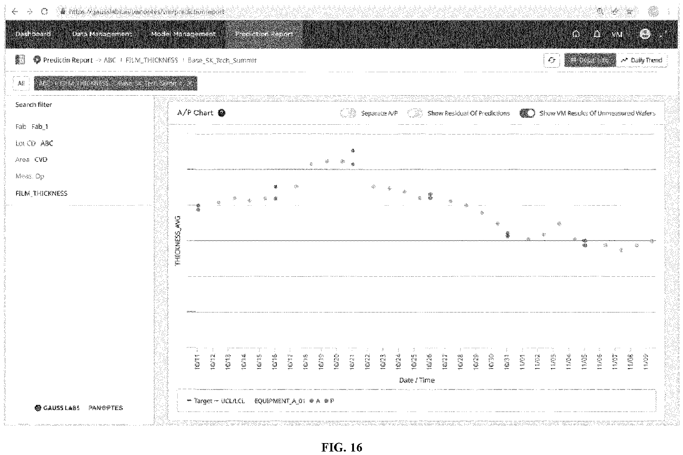

In some embodiments, the process control module is configured to use the one or more predicted metrics to improve process productivity via integration with run-to-run control. In some cases, systems and methods described herein may be integrated into manufacturing processing lines as a run-to-run system in real time. In some embodiments, the system is configured to be used or deployed in a manufacturing environment. A run-to-run system can generally include methods for modifying recipes associated with processes in real time. Recipes can include a set of instructions for performing processes in manufacturing processes. Recipes may be associated with parameters. For example, recipes and parameters for chemical vapor deposition processes may include a deposition instruction with parameters specifying a power level, e.g., a specified current and voltage. Additionally, a run-to-run system can generally include methods for modifying control parameters associated with processes in real time, e.g., process variables of equipment for chemical vapor deposition such as pressure, gas quantity, power, temperature, electrical current, and the like. In some cases as shown in FIGs. 15-16, modifying control parameters, recipes, or models may be performed using graphical user interfaces (GUI). For example, users can create their own models incorporating their expertise or can compare actual and predicted process outcomes. Systems and methods described herein can include methods for generating real time predictions about data drifts, data shifts, hierarchical data structures, or deviations in process or equipment and for inferring or characterizing outputs of manufacturing processes. Inferred or characterized outputs can be used to modify recipe parameters or control parameters in real time feedback loops to improve prediction performance of process variables or target properties.

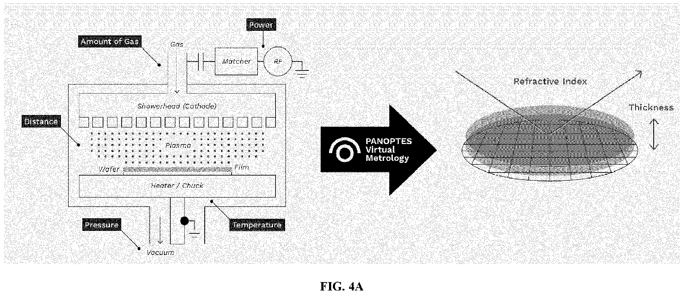

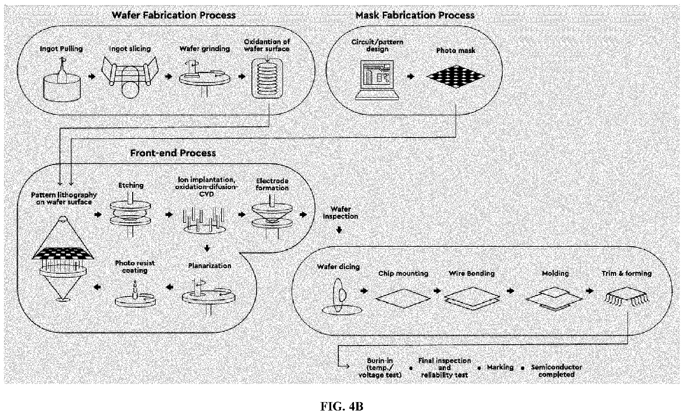

In some embodiments, the system further comprises the process equipment, wherein said process equipment comprises a semiconductor process equipment. For example as shown in FIGs. 4A-4B, process equipment can include equipment associated with semiconductor wafer production, oxidation, photolithography, etching, deposition, ion implantation, metal wiring, electrical die sorting, packaging, and the like. In some embodiments, the deposited or fabricated structure comprises a film, a layer, or a substrate. Systems and methods described herein may be configured to monitor or control target properties or process variables. Target properties may be associated with wafer films, layers, or substrates. Alternatively or additionally, target properties may include mechanical, electrical, or structural properties of products. For example, electrical properties of wafers can include controlling and monitoring conductivity of wafers via doping processes. Mechanical properties of wafers can include controlling and monitoring strain of wafers via metalorganic vapor-phase epitaxy processes. Structural properties can include controlling and monitoring a thickness of film or a refractive index of film via chemical vapor deposition processes. In some embodiments, the one or more predicted metrics comprise one or more dimensions or properties of the film, the layer, or the substrate.

### Data processing

In some embodiments, the plurality of data types and datasets comprise: (1) historical process data, (2) current process data, (3) historical measurement data of the one or more predicted metrics, (4) current measurement data of the one or more predicted metrics, (5) operation data, and/or (6) equipment specification data. As described elsewhere herein, systems and methods may be associated with virtual metrology systems and methods. Virtual metrology systems and methods can generate substantial amounts of data. Data may include contemporary (e.g., current or real time) data or historical data. Contemporary data or historical data may be associated with sensor data, sensor specification data, process data, process specification data, measurement data, operation data, equipment data, or equipment specification data. For example, data can comprise fault detection and classification (FDC) data, sensor data (e.g., temperature, pressure, power, electrical current, gas quantities, and the like), measurement data (e.g., film thickness, film refractive index, critical dimensions, and the like), or operations data.

In some cases, systems and methods disclosed herein can support processing of manufacturing data in streaming modes or batch modes. Streaming modes may generally include data received in real time during the course of manufacturing processes, e.g., contemporary or real time data. Batch modes may generally include data received in other than real time from manufacturing processing, e.g., historical data.

In some embodiments, the data processing module is configured to validate the historical process data and the historical measurement data against the operation data and the equipment specification data. Validation of historical process data against operation data or equipment data can be associated with threshold values. In some cases, historical process data may be validated when a threshold value is at least about 60%, 70%, 80%, 90% or more of data associated with operation data or equipment data. Validation of historical measurement data against operation data or equipment data can be associated with threshold values. In some cases, historical measurement data may be validated when a threshold value is at least about 60%, 70%, 80%, 90% or more of data associated with operation data or equipment data. Threshold values can be associated with a prescribed standard deviation. In some cases, validation of historical process data may be validated when a threshold value is within at least about 3 standard deviations ($3\sigma$), 2 standard deviation ($2\sigma$), or 1 standard deviation ($1\sigma$) of operation data or equipment data. In some cases, validation of historical measurement data may be validated when a threshold value is within at least about 3 standard deviations ($3\sigma$), 2 standard deviation ($2\sigma$), or 1 standard deviation ($1\sigma$) of operation data or equipment data.

In some embodiments, the plurality of sources comprise a database that is configured to store at least the historical process data or the historical measurement data. In some cases, the plurality of sources can include a database that is configured to store contemporary or real time process data. In some cases, the plurality of sources can include a database that is configured to store contemporary or real time measurement data. Some or all data can be stored in one or more databases. In some cases, the plurality of sources can include a database that is configured to store a subset of contemporary or real time process data. In some cases, the plurality of sources can include a database that is configured to store a subset of contemporary or real time measurement data. A subset of data can comprise at least about 25%, 50%, 75%, or more of data associated with historical process data, historical measurement data, contemporary process data, or contemporary measurement data.

In some embodiments, the plurality of sources comprise a database or a log that is configured to store at least the operation data or the equipment specification data. In some cases, the plurality of sources can include a database that is configured to store contemporary or real time or historical operation data. In some cases, the plurality of sources can include a database that is configured to store contemporary or real time or historical equipment specification data. Some or all data can be stored in one or more databases. In some cases, the plurality of sources can include a database that is configured to store a subset of contemporary or real time or historical operation data. In some cases, the plurality of sources can include a database that is configured to store a subset of contemporary or real time or historical equipment specification data. A subset of data can comprise at least about 25%, 50%, 75%, or more of data associated with historical operation data, historical equipment specification data, contemporary operation data, or contemporary equipment specification data.

In some embodiments, the plurality of sources comprises the process equipment. As described elsewhere herein, manufacturing processes may be associated with process equipment that include one or more setpoints that the engineer/designer can set. For example, process equipment in semiconductor manufacturing processes can include equipment associated with wafer production, oxidation, photolithography, etching, deposition, ion implantation, metal wiring, electrical die sorting, packaging, and the like. The user is able to set various setpoints for any of these equipment, such as temperature, angles, heights, depths, widths, sizes, amounts of material, and many others.

In some embodiments, the plurality of sources comprise a measurement equipment configured to collect the current measurement data. As described elsewhere herein, manufacturing processes may be associated with measurement equipment. Measurement equipment can include measurement tools or instruments configured to measure target properties. For example, measurement tools or instruments may be used to measure target properties in semiconductor manufacturing processes such as film thickness, refractive index, critical dimensions, and the like for wafers.

In some embodiments, the data processing module is configured to receive and process the plurality of data types or datasets by generating a component hierarchical structure of the process equipment. Manufacturing processes can be associated with process equipment having subsystems, e.g., components. Manufacturing processes can include at least 1, 2, 3, 4, 5, or more types of process equipment. Process equipment can be all of the same type of process equipment. Process equipment can be of different types of process equipment. Components of process equipment can include sensors configured to collect data associated with process variables.

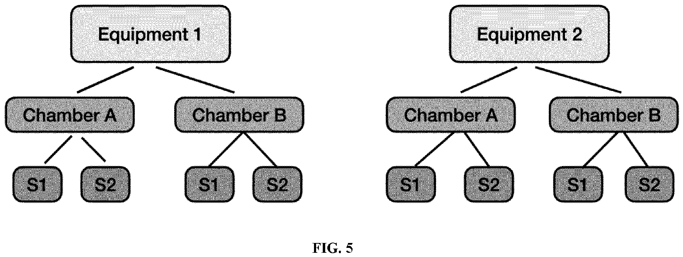

In some embodiments, the component hierarchical structure comprises a nested structure of (i) the process equipment and (ii) one or more components that are used within or in conjunction with the process equipment. For example as shown in FIG. 5, semiconductor manufacturing processes may include chemical vapor deposition processes associated with process equipment, e.g., equipment 1, equipment 2, and so on. Components of process equipment can include chambers for performing chemical vapor deposition processes, e.g., chamber A, chamber B, and so on. Chambers can include stations configured to measure sensor data such as temperature, pressure, power, electrical current, gas quantities, and the like, e.g., station S1, station S2, and so on. In some embodiments, the one or more components comprise one or more sub-equipment including chambers, stations, and/or sensors.

In some cases, manufacturing processes may comprise many different types of processes having different types of process variables or target properties. As described elsewhere herein, systems and methods can scale by aggregating data from sensors of more than one process equipment or more than one sensor. Aggregating data from processes, process equipment, or sensors can improve generating predicted metrics, e.g., predictions of target properties or process variables. For example, by aggregating and processing data from multiple equipment chambers for a same process step, sparse datasets can still be used to generate reliable, robust, and scalable virtual metrology models by training machine learning algorithms described herein.

In some embodiments, the data processing module is configured to receive and process the plurality of data types or datasets by generating a step-operation hierarchical structure of a recipe for the process. For example as shown in Table 1, a recipe for chemical vapor deposition in semiconductor manufacturing processes may include a recipe or method having operations and sub-operations. Operations can include loading, preparing, depositing, unloading, or cleaning. Sub-operations for depositing can include controlling voltage or current to generate a prescribed power. In some embodiments, the recipe comprises a plurality of steps, and wherein each step of the plurality of steps comprises a plurality of different sub-operations. Operations or sub-operations may be associated with data types or datasets related to process variables or target properties. Process variables may include, for example, pressure, gas quantity, power, temperature, and the like for chemical vapor deposition processes. Target properties may include, for example, film thickness or refractive index of a semiconductor wafer processed via chemical vapor deposition processes.

**Table 1**

| Operations | Sub-operations |
|---|---|
| Loading | Moving stage; Locking sample; etc. |
| Preparing | Preheating; Powering on plasma; etc. |
| Depositing | Controlling voltage; Controlling current; etc. |
| Unloading | Moving stage; Unlocking sample; etc. |
| Cleaning | Purging gas; Cooling; etc. |

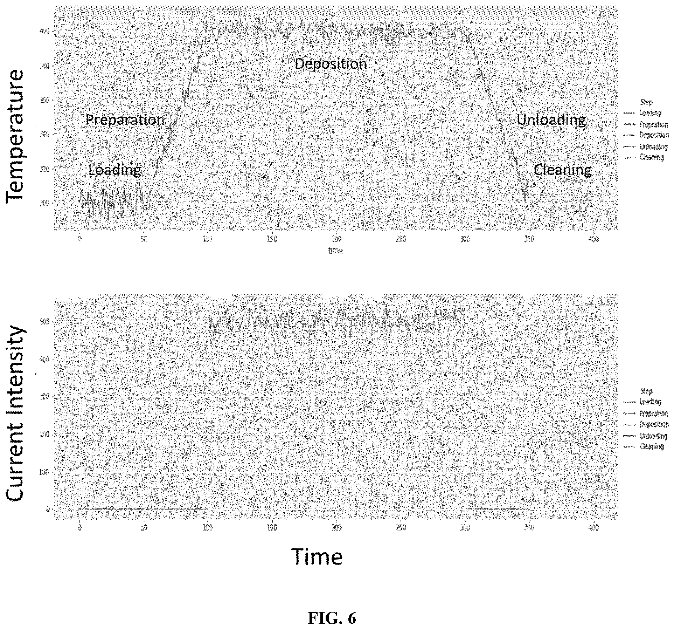

In some embodiments, the data processing module is configured to receive and process the plurality of data types or datasets by removing one or more data outliers. The plurality of data types or datasets may include data in raw or unadulterated form, e.g., trace data. For example, FIG. 6, depicts trace data associated with process variables related to operations or sub-operations of chemical vapor deposition processes. Process variables can include, for example, temperature, power, or electrical current of chemical vapor deposition processes. In some cases, trace data may be processed to generate clean data. Generating clean data can include, for example, handling irregular data or removing data outliers (e.g., inside or outside a prescribed threshold) based on process specifications, equipment specifications, or sensor specifications. Data can be contemporary data (e.g., current or real time data) or historical data. In some embodiments, the data processing module is configured to pre-process and remove data outliers from the process data before the process data is input to the model in the inference module.

In some embodiments, the training data is continuously updated with the current process data and the current measurement data. Features can be extracted from trace data or clean data to generate training data, test data, or validation data. The training and optimization module may use features to train and optimize virtual metrology models via a machine learning pipeline.

### Model training pipeline

In some embodiments, the machine learning pipeline comprises two or more components from a plurality of components comprising of (i) feature engineering, (ii) time-aware data normalization, and/or (iii) an adaptive learning algorithm. Feature engineering can generally include extracting features and selecting features that determine the main characteristics of time-series data having data drifts, data shifts, hierarchical data structures, or deviations of data in processes or process equipment. Feature engineering may be associated with correlation coefficients or variable shrinkage. Time-aware data normalization can generally include decomposing time series data into multiple components and individually tuning components of processes. Time-aware data normalization may be associated with differentiation or moving averages. Adaptive learning methods or algorithms can generally include determining changing relationships between input data (e.g. process variables such as feaures or sensor data) and output data (e.g., process variables or target properties). Adaptive learning methods or algorithms may be associated with rolling regression or online regression. The one or more combinations of feature engineering, time-aware data normalization, or adaptive learning algorithms can improve prediction performance of target properties or process variables in advanced process control and monitoring. In some embodiments, the machine learning pipeline is configured to apply the training data through the two or more components sequentially or simultaneously.

As described elsewhere herein, advanced process control and monitoring may be associated with virtual metrology systems and methods. Virtual metrology systems and methods may be associated with machine learning systems and methods. Machine learning systems and methods can use data from manufacturing processes to train, test, and validate virtual metrology models. Virtual metrology models can generate adaptive, online time-series predictions for use in virtual metrology. Predictions may include predictions for process variables or target properties in manufacturing processes such as semiconductor manufacturing processes.

Virtual metrology models disclosed herein can handle technical challenges specific to data associated with semiconductor manufacturing processes such as data drifts, data shifts, hierarchical data structures, or deviations of data in processes or process equipment. As described elsewhere herein, systems and methods may compare actual data (e.g., raw or trace data from contemporary or historical sensor data) to specified or certified process or equipment data, e.g., equipment specifications or process specifications. Actual data in disagreement with specified or certified data outside of a prescribed threshold may be further processed before use in building in machine learning models such as virtual metrology models. Virtual metrology models can enable more efficient workflows for controlling and monitoring manufacturing processes.

Generating machine learning models (e.g., virtual metrology models) via a machine learning pipeline may generally include receiving data, preprocessing data, selecting or engineering features from data, training models using data or features, testing models using data or features, or validating models using data or features. Validated models can be deployed or integrated into manufacturing processes. Data or features can include data or features generated from multiple iterations of training, testing, or validating via machine learning pipelines. Data or features can include data or features generated from multiple instances of manufacturing processes. Multiple instances can occur during different time periods or during same time periods. Data or features can be automatically tracked or used in real time. Data or features can be stored for review and used during a later time. In some embodiments, the time-aware data normalization comprises a decomposition of time series data into one or more components including smoothing data, trend data, and/or detrend data.

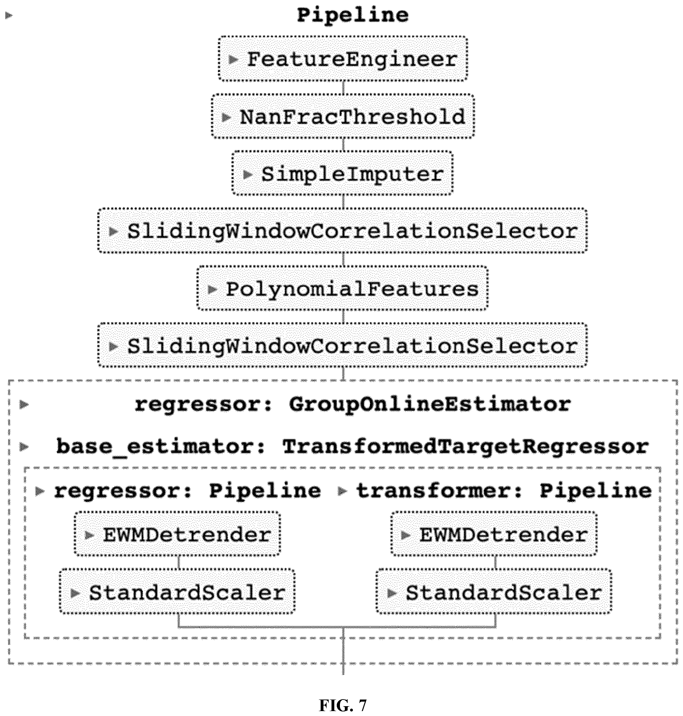

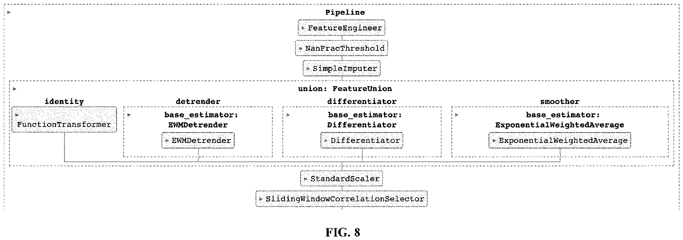

FIGs. 7 and 8 depict operations that may be associated with feature engineering in a machine learning pipeline. Feature engineering can generally include operations for feature creation, transformation, feature extraction, or feature selection. Feature engineering operations can comprise at least 1, 2, 3, 4, 5, or more operations. Feature engineering operations can comprise at most 5, 4, 3, 2, or 1 operations. In some cases, feature engineering operations can include operations such as feature engineer (e.g., performing combinations of columns), nan frac threshold (e.g., removing columns with values above a threshold that are not a number (NaN)), simple imputer (e.g., performing mean imputation of missing values), sliding window correlation selector, or polynomial features (e.g., multiplying columns together). In some cases, feature engineering operations can include operations such as feature engineer, nan frac threshold, simple imputer, function transformer such as detrender, differentiator, exponential weighted average, standard scaler, or sliding window correlation selector.

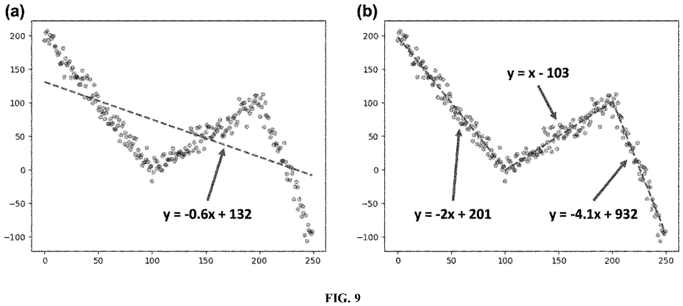

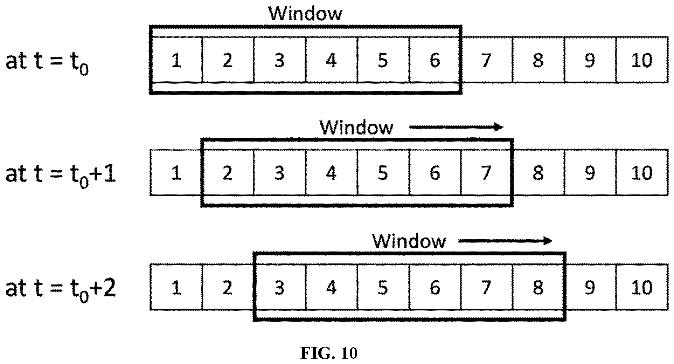

In some embodiments, the feature engineering comprises an extraction of a plurality of features from raw trace data or sensor data within the training data. Compared to methods using global relationships, sliding window methods can better determine local relationships for data having non-stationary characteristics. Non-stationary characteristics can include, for example, data drifts or data shifts described elsewhere herein. In some embodiments, the feature engineering comprises use of an algorithm to select one or more features from a list of extracted features, based at least in part on local relationships between an input and an output of the model. For example as shown in FIG. 9, methods using global relationships can inaccurately determine relationships between input data and output data. Methods using global relationships may predict a relationship between an output (y) and an input (x) as y = -.6x + 132 for all time points even though three distinct time periods exist. Sliding window methods can predict the changing relationship between an output (y) and an input (x) for the three distinct time periods of the trace data as y = -2x + 201, y = x - 103, and y = -4.1x + 932. FIG. 10 conceptually depicts sliding window methods. Sliding window methods may determine running correlations between output and input data by (i) sliding a window across a time series of data and (ii) averaging correlations as a selection score. In some embodiments, the time-aware data normalization is based on a model and a data type of the model. The correlation of the $i^{th}$ feature can be determined using the equation:

$$r_i = \frac{1}{J(T-W)} \sum_{j=1}^{J} \sum_{t=1}^{T-W} r_{ij}(t)$$

$$r_{ij}(t) = corr\big(X_i[t:t+W], Y_j[t:t+W]\big)$$

where i is $i^{th}$ variable of input data (e.g., X data, features, sensor data); j is the $j^{th}$ variable of output data (e.g., Y data, responses, targets, measurements); r is the correlation coefficient; T is the total number of input data; W is the window size; and J is total number of variables of output data.

In some embodiments, the adaptive learning algorithm is an adaptive online ensemble learning algorithm. A single machine learning model may not be able to accurately predict all process variables or target properties with a prescribed confidence level. Accordingly, methods disclosed herein can generate, maintain, or update two or more models for use in an ensemble model to predict process variables or target properties with a prescribed confidence level. Models may predict process variables or target properties with a confidence level of at least about 60%, 70%, 80%, 90%, 95% or better. In some cases, models may predict process variables or target properties with a confidence level of at least about 95%. Systems and methods described herein can generate, maintain, or update multiple machine learning models for selection in different manufacturing processes to improve prediction performance. In some cases, systems and methods described herein can, for example, validate performance of machine learning models on multiple manufacturing processes or targets to generate best-performing models. After automatically generating benchmarking tests on process variables or target properties, best-performing machine learning models can be deployed in an agile manner with few or no human operations.

### Model optimization

In some embodiments, the training and optimization module is configured to optimize the model using at least in part hyperparameter optimization. In some cases, virtual metrology models disclosed herein can be trained using hyperparameter optimization with streaming data or batch data. Hyperparameter optimization (e.g., tuning of hyperparameters in machine learning models) may be used for one, more than one, or all processes of a manufacturing process. Hyperparameter optimization for all or substantially all processes of a manufacturing process can improve overall prediction performance by searching a shared set of hyperparameters across processes, which may alleviate overfitting, compared to optimizing on one process or a few processes. In some cases, hyperparameter optimization may improve prediction performance by at least about 1%, 5%, 10%, 20% or more when optimizing for all or substantially all processes compared to optimizing on a few processes or one process. A few processes can be at most about 30%, 20%, 10%, or less of all processes.

In some embodiments, the training and optimization module is configured to (i) train the model with a given set of hyperparameters on an output from the machine learning pipeline. In some cases, systems and methods disclosed herein may process data from many different sensors, different equipment, or different processes and select the most relevant features. Training and optimization may include using hyperparameter optimization on one or more features for better prediction performance of target properties or process variables. For example, referring to FIGs. 7 or 8, hyperparameters associated with sliding window correlation selector may include multicollinearity and the like. Hyperparameters associated with polynomial features may include number of degrees and the like. Hyperparameters associated with detrender may include half life, change point, and the like. Hyperparameters associated with scaler may include type of scaler and the like.

In some embodiments, the training and optimization module is further configured to (ii) evaluate a performance of the model based on validation data. Systems and methods described herein can track temporal changes in sensor data, equipment data, or process data to continuously update or optimize virtual metrology models. Testing data, training data, or validation data may change over time and so can change local or global relationships between input data and output data over time. Performance of models can be continuously improved over time by training, testing, or validating models using other training data, other testing data, or other validation data that is different than previous training data, previous testing data, or previous validation data.

In some embodiments, the validation data is split from the training data for the hyperparameter optimization. Splitting data for training, testing, or validation (e.g., split validation) can be performed using prescribed percentages. For example, data may be split into 80% for training and 20% for testing. Data may be split into 80% for training, 10% for testing, and 10% for validation. Alternatively or additionally, splitting data can be performed using cross validation, e.g., exhaustive cross validation or non-exhaustive cross validation like k-fold validation.

In some embodiments, the training and optimization module is further configured to (iii) use a hyperparameter optimization algorithm to select a set of hyperparameters for a next iteration based on past performance, so as to increase or improve the performance of the model. Systems and methods described herein may use methods associated with algorithms for selecting hyperparameters for hyperparameter optimization. For example, a set of hyperparameters can be determined to improve prediction performance over another or previous set of hyperparameters. The set of hyperparameters can be used for the next integration of training, testing, or validating a model to increase or improve the prediction performance of the model.

In some embodiments, the training and optimization module is further configured to repeat (i)-(iii) iteratively until the performance of the model meets termination criteria. In some cases, termination criteria can be a prescribed metric based on absolute values of the metric. Alternatively or additionally, termination criteria can be a prescribed metric based on relative changes in the metric. Termination criteria can include no change in the metric over a given number of epochs, an absolute change in the metric, a decrease in prediction performance observed over a given number of epochs, or an average change in the metric over a given number of epochs.

In another aspect, disclosed herein are methods for process monitoring and control. Methods may include, for example, (a) receiving and processing a plurality of data types and datasets from a plurality of different sources for generating training data; (b) providing the training data to a machine learning pipeline for training and optimizing a model; and (c) generating one or more predicted metrics substantially in real-time, wherein the one or more predicted metrics are useable to characterize an output of a process performed by a process equipment.

## Machine learning methods for predictions in process monitoring and control

Many machine learning (ML) methods implemented as algorithms are suitable as approaches to perform the methods described herein. Such methods include but are not limited to supervised learning approaches, unsupervised learning approaches, semi-supervised approaches, or any combination thereof.

Machine learning algorithms may include without limitation neural networks (e.g., artificial neural networks (ANN), multi-layer perceptrons (MLP), long short-term memory (LSTM)), support vector machines, k-nearest neighbors, Gaussian mixture model, Gaussian process, naive Bayes, decision trees, random forest, or gradient boosting trees. Linear machine learning algorithms may include without limitation linear regression with or without regularizer, logistic regression, naive Bayes classifier, perceptron, or support vector machines (SVMs). Other machine learning algorithms for use with methods according to the disclosure may include without limitation quadratic classifiers, k-nearest neighbor, boosting, decision trees, random forests, neural networks, pattern recognition, Bayesian networks, or Hidden Markov models. Other machine learning algorithms, including improvements or combinations of any of these, commonly used for machine learning, can also be suitable for use with the methods described herein. Any use of a machine learning algorithm in a workflow can also be suitable for use with the methods described herein. The workflow can include, for example, cross-validation, nested-cross-validation, feature selection, row compression, data transformation, binning, normalization, standardization, and algorithm selection.

A machine learning algorithm can generally be trained by the following methodology to build a machine learning model. In some cases, generated models may determine or predict target properties of products e.g., film thickness or refractive index of wafers. Input data can include, for example, process variables such as X data, features, fault detection and classification (FDC) data, sensor data, and the like described elsewhere herein. Output data can include, for example, target properties such as Y data, responses, measurements, and the like described elsewhere herein. In some cases, generated models may determine or predict process variables. Input data can include, for example, process variables described elsewhere herein. Output data can include, for example, process variables described elsewhere herein.

1. Gather a dataset for "training" and "testing" the machine learning algorithm. The dataset can include many features, for example, features associated with sensor data, equipment, processes, and the like. The training dataset is used to "train" the machine learning algorithm. The testing dataset is used to "test" the machine learning algorithm.

2. Determine "features" for the machine learning algorithm to use for training and testing. The accuracy of the machine learning algorithm may depend on how the features are represented. For example, feature values may be transformed using one-hot encoding, binning, standardization, or normalization. Also, not all features in the dataset may be used to train and test the machine learning algorithm. Selection of features may depend on, for example, available computing resources and time or importance of features discovered during iterative testing and training. For example, it may be discovered that features associated with sensor data or equipment specifications are predictive for process variables or target properties.

3. Choose an appropriate machine learning algorithm. For example, a machine learning algorithm described elsewhere herein may be chosen. The chosen machine learning algorithm may depend on, for example, available computing resources and time or whether the prediction is continuous or categorical in nature. The machine learning algorithm is used to build the machine learning model.

4. Build the machine learning model. The machine learning algorithm is run on the gathered training dataset. Parameters of the machine learning algorithm may be adjusted by optimizing performance on the training dataset or via cross-validation datasets. After parameter adjustment and learning, the performance of the machine learning algorithm may be validated on a dataset of naive samples that are separate from the training dataset and testing dataset. The built machine learning model can involve feature coefficients, importance measures, or weightings assigned to individual features.

Once the machine learning model is determined as described above ("trained"), it can be used to generate predictions for process monitoring and control in manufacturing processes such as semiconductor manufacturing processes.

## Examples

While various examples of the disclosure have been shown and described herein, such examples are provided by way of example only. Numerous variations, changes, or substitutions may occur without departing from the disclosure. It should be understood that various alternatives to the examples described herein may be employed.

### *Example 1 - Adaptive online time-series prediction for virtual metrology in semiconductor manufacturing processes*

*Introduction*

Systems and methods described herein (e.g., virtual metrology (VM) models) were used to model wafer characteristics statistically, using sensor data and historical measurements, for predicting, controlling, and monitoring semiconductor manufacturing processes, e.g., chemical vapor deposition (CVD) processes. Virtual metrology models increased productivity, improved quality, and lowered maintenance costs by reducing physical or human inspections associated with semiconductor manufacturing processes.

Compared to systems and methods described herein, other methods (e.g., algorithmic methods or models) may not work with data having data drifts or data shifts observed in semiconductor manufacturing processes. Data drifts generally refer to gradual changes of process dynamics due to, e.g., equipment aging. Data shifts generally refer to abrupt changes in process dynamics due to, e.g., external operations such as maintenance, calibration, or layer changes.

To use virtual metrology models reliably in advanced process control and monitoring, a model's predictions should be highly accurate at all times of a process. Some models, however, cannot handle non-stationarities observed in sensor data or measurement data generated by, e.g., chemical vapor deposition, etching, diffusion, or other processes. Data drifts can cause steady or slow decreases in a model's accuracy. Data shifts can cause abrupt failures of models. For example, Gaussian processes solutions or neural network architectures may generate incomplete solutions or predictions by focusing primarily on data drifts. For example, window-based models may generate unreliable predictions or fail when data shifts occur due to fixed window sizes. For example, just-in-time learning models may not adapt to changes in relationships between inputs and outputs.

Systems and methods described herein use a novel time-series prediction framework incorporating time-aware data normalization methods and adaptive learning methods to generate accurate virtual metrology models (*See* FIGs. 1 and 2). Time-aware normalization methods can remove data drifts from data. Methods may use various smoothing algorithms, e.g., exponentially weighted moving averages for performing this transformation. Adaptive learning methods can capture time-varying relationships between responses (e.g., outputs) and inputs. Systems and methods described herein can also generate an ensemble of predictions of several models to deliver more accurate predictions in data-shifting environments to reduce process variability on real production lines in manufacturing processes.

*Adaptive online time-series prediction*

Systems and methods described herein (e.g., adaptive online time-series methods, algorithms, or models) may integrate two complementary strategies or operations into a pipeline process to overcome data drifts or data shifts. The pipeline may include time-aware normalization methods and adaptive online learning methods. Methods may normalize inputs or outputs with, e.g., a moving average method to remove data drifts from data to generate transformed data so that distributions of inputs or outputs remain consistent through time. Methods may provide transformed data as inputs into the adaptive online learning algorithm to capture changing relationships between variables by factoring in variations in the dynamics of processes. Both operations can complement each other to solve different problems, e.g., chamber drift or concept drift. Chamber drift can generally occur when a change in the chamber's state modifies the sensors' outputs. Concept drift can generally alter relationships between sensors and measurements. Time-aware normalization methods herein can solve chamber drift to handle drifting distributions. Adaptive online learning methods herein can solve concept drift to handle changing relationships.

*Time-aware normalization methods*

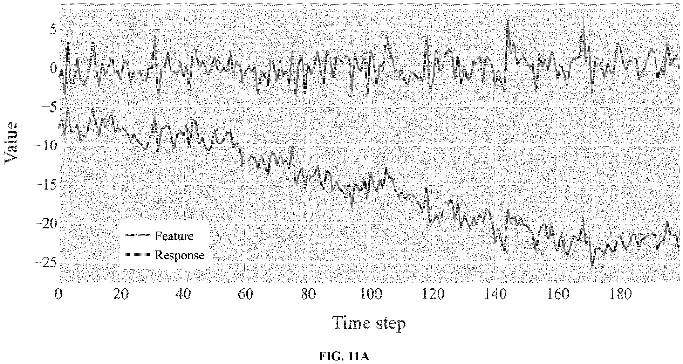

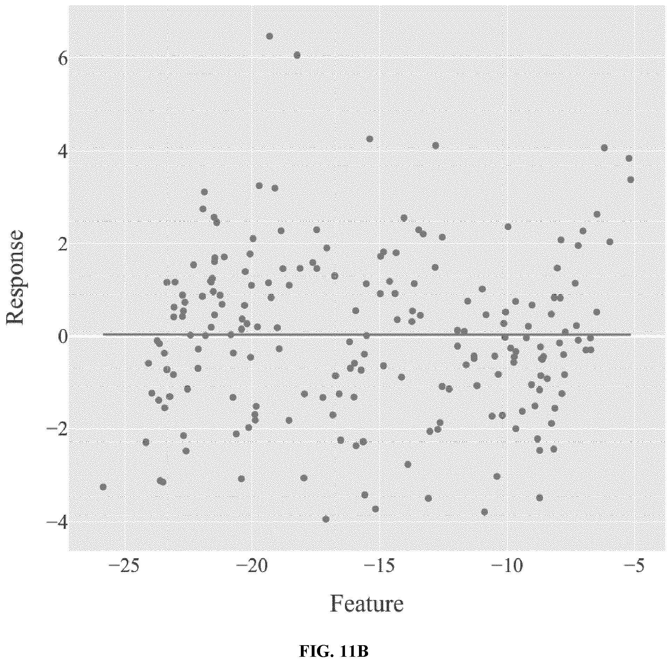

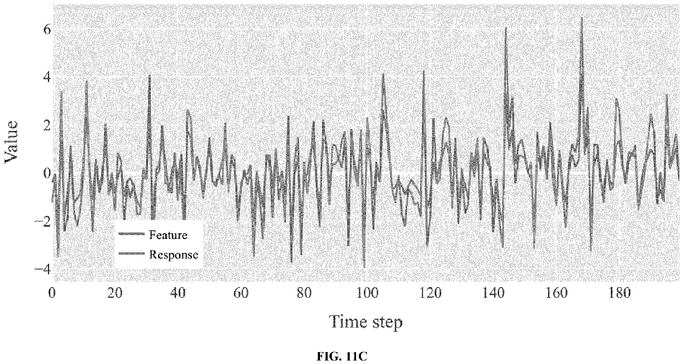

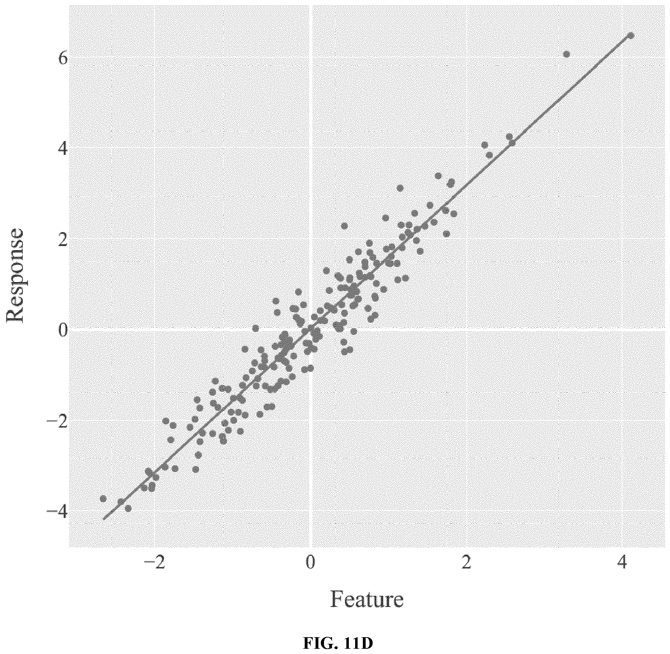

Time-aware normalization methods can reduce effects of data drift on prediction accuracy. In virtual metrology datasets associated with semiconductor manufacturing processes, features can slowly and steadily drift over time. Data drift can create distortions between inputs and outputs and reduce prediction accuracy over time. Time-aware normalization methods can remove such changes to restore relationships between features and targets. For example, FIGs. 11A-11D show how a drifting input can hide a linear relationship. In FIGs. 11A-11B, the feature slowly drifts away from its initial range while the response remains stationary. Consequently, the correlation between input and output is null. Applying time-aware normalization methods to the feature can recover the linear relationship as illustrated in FIGs. 11C-11D.

Mean, scale, sampling rates, slopes, or any statistics may change over time and impact the prediction performance of virtual metrology models. Accordingly, time-aware normalization methods can use different approaches. For example, differencing, smoothing, detrending, online estimation of various parameters, or time series decomposition methods may be required depending on what data is drifting. Systems and methods described herein may use, e.g., exponential weighted moving averages to automatically transform both the inputs and the outputs. By adequately weighing each data point based on observation time, methods described herein can ensure that inputs and outputs are consistent over time. After transforming data through time-aware normalization methods, transformed data can be provided as input data for adaptive online learning methods.

*Adaptive online learning methods*

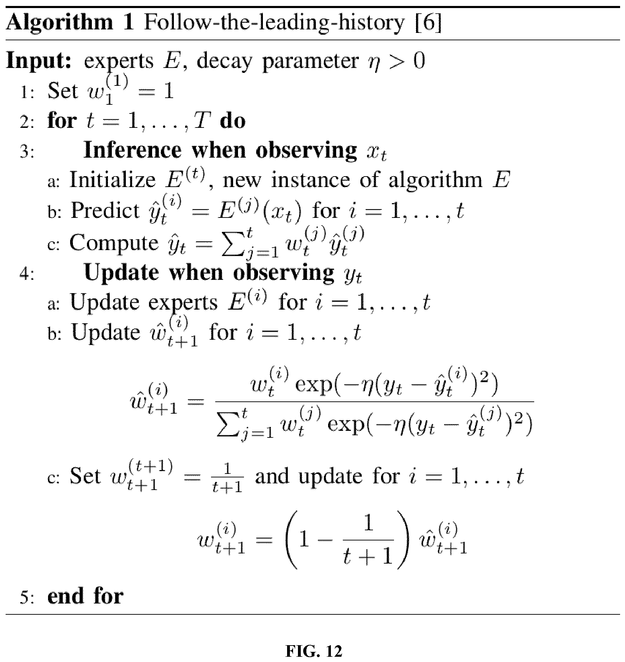

Adaptive online learning methods described herein can handle changes in input-output relationships. Methods can model these relationships as they change over time. Methods may aggregate multiple online experts (e.g., regressors) by evaluating them based on their current and past performances. Methods may emphasize the best-performing experts for any given time window by minimizing adaptive regret. Adaptive regret generally measures how well algorithms perform compared to the optimum in hindsight on every time interval. At each time point, the best regressors contribute the most to a prediction. A pseudo-code, illustrated by example in FIG. 12, can give an intuition on how an individual expert contributes to a final prediction. At each time point t, the weight of expert i varies based on its residuals. Higher residuals lead to smaller weights relative to other experts. Experts may include, e.g., linear models, gaussian processes, decision tree regressors, or any online regressor. Choosing the right regressor can be important to the performance of the adaptive online learning model in terms of, e.g., speed or accuracy. To control how fast the ensemble adapts to changes, the decay parameter $\eta$ can be tuned based on the dynamics of the process.

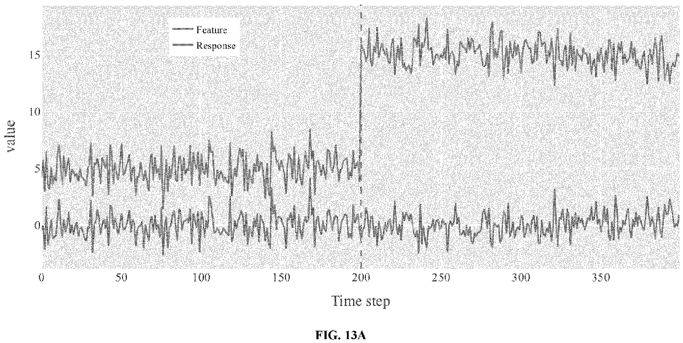

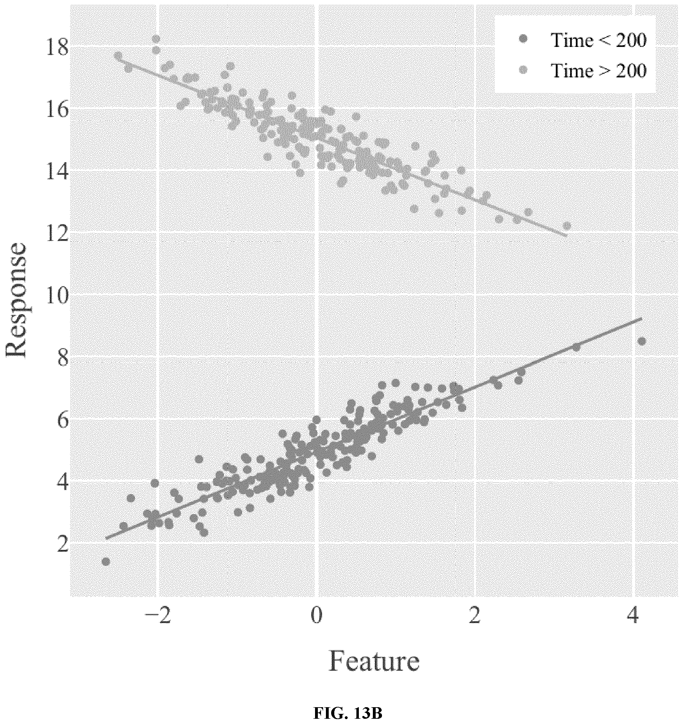

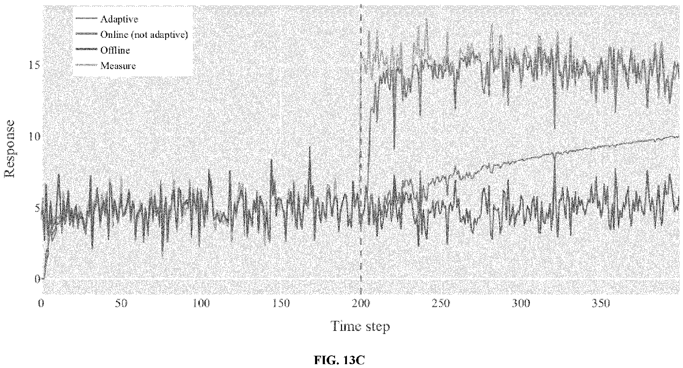

FIGs. 13A-13C provide an example of adaptive online learning methods modeling a simple univariate linear relation, FIG. 13A, where $y = a_t x + b_t$ where $(a_t, b_t) = (1,5)$ for $t \leq 200$ and $(a_t, b_t) = (-1, 15)$ for $t \geq 200$. Assuming that points after t = 200 are unobserved at test time, offline algorithms trained on data from $t \leq 200$ may provide inaccurate predictions. On the other hand, other online methods without adaptation may struggle to adjust after the abrupt shift. Furthermore, while time-aware normalization methods presented above could reduce the effect of the shifting intercept, it may not be able to handle the flipping coefficient as illustrated in FIG. 13B. Because the model changes completely, an adaptive online learner model may be required. FIG. 13C compares prediction performance of a linear regressor method, an online linear regressor method, and adaptive online learning methods of the present disclosure using an online linear regressor as the base expert. Methods disclosed herein provide more accurate predictions than the linear regressor and the online linear regressor. The linear regressor does not adjust to the model change. The online linear regressor provides inadequate predictions and does not reach the right regimen in time.

*Results*

Systems and methods described herein were used to generate predictions for chemical vapor deposition processes using both synthetic data and actual data from manufacturing processes.

Synthetic data. Synthetic data included a dataset reproducing the behavior of carbon deposition processes. The dataset, shown in FIG. 14A, included a concatenated sample of five regression problems of 200 samples and 10 features. Each regression problem had different coefficients and intercepts. In this concatenated dataset, a model change occurred every 200 time steps to determine how quickly each method adapted to data shifts. Additionally, random data drifts were generated in each feature. FIG. 14B shows two features evolving through time. In this synthetic dataset, the features drift, and the response shifts. This synthetic dataset may emulate data shifts caused by, e.g., maintenance, recipe changes, or calibration operations and data drifts arising from, e.g., aging equipment.

Systems and methods disclosed herein were compared with other virtual metrology methods using rolling ordinary least squares (OLS) methods and online linear methods (also known as recursive least squares). Rolling OLS methods may be parameterized by a window size and a stride. In each window, a linear model can be fitted. This model may make predictions until the window strides and a new model is estimated and used for prediction. In online linear methods, coefficients and intercept can be updated whenever a response is observed. By default, these methods may not have specific adaptation mechanisms.

Each model was trained on a training dataset and tuned on an evaluation dataset. The performance was measured on a separate test dataset. The training and evaluation datasets covered the first 600 points. The test dataset included the last 400 points. By construction, the test datasets contain data drifts and data shifts unobserved during training. Table 2 summarizes the coefficient of determination ($R^2$) and the root mean squared error (RMSE) for the three methods on the test dataset. Adaptive online time-series methods described herein improved the regression metrics compared to rolling OLS methods by as much as 24% and 48% for $R^2$ and RMSE, respectively.

**Table 2**

| Model | $R^2$ | RMSE |
|---|---|---|
| Online linear model | 0.02 | 1.25 |
| Rolling OLS model | 0.75 | 0.64 |
| Model disclosed herein | 0.93 | 0.33 |
| Improvement | 24% | 48% |

FIGs. 14C-14D compare the performance of rolling OLS methods, online linear methods, and methods described herein. Adaptive online time-series methods described herein adapt much faster to shifts compared to rolling OLS methods. As shown in FIG. 14C, at timestamps 600 and 800, methods described herein take about 25 points to adapt to the data shift while rolling OLS methods take about 50 points. Online linear methods fail to adapt to the abrupt data shifts. FIG. 14D compares the absolute residuals of the three methods. Methods disclosed herein limit the magnitude of the error right after the data shift. While the average absolute residuals can reach as high as 2 for rolling OLS methods and online linear methods, they remain around or under 1 for methods described herein. After about 50 to 60 points after the data shifts, rolling OLS methods and methods describe herein recover the underlying model and perform similarly. Online linear methods fail to adapt quickly enough and never reach adequate performance.

Adaptive online time-series methods described herein outperform rolling OLS methods because of their adaptation speed. Window methods may be limited by their window size. When a window overlaps two inconsistent ranges of data, performance can be impacted. Aggregation of regressors fitted over different time ranges can reduce the impacts of data shifts. Because the adaptive model described herein consistently trains and updates experts, young and relevant experts are ready as soon as a shift occurs.

Actual data. Systems and methods described herein (e.g., adaptive online time-series methods) were also deployed and integrated into the advanced process control and monitoring system of a major semiconductor manufacturer. Models covered four thin film vapor depositions on memory chip processes using 72 deposition chambers. Memory chip processes included dynamic random access memory (DRAM) and "not and" (NAND) processes. By running the system in daily advanced process control operations for several months, systems and methods described herein achieved at least about a 45.2% reduction (about a 21.5% reduction on average) in the variance of the film thickness and refractive index.

## Computing systems

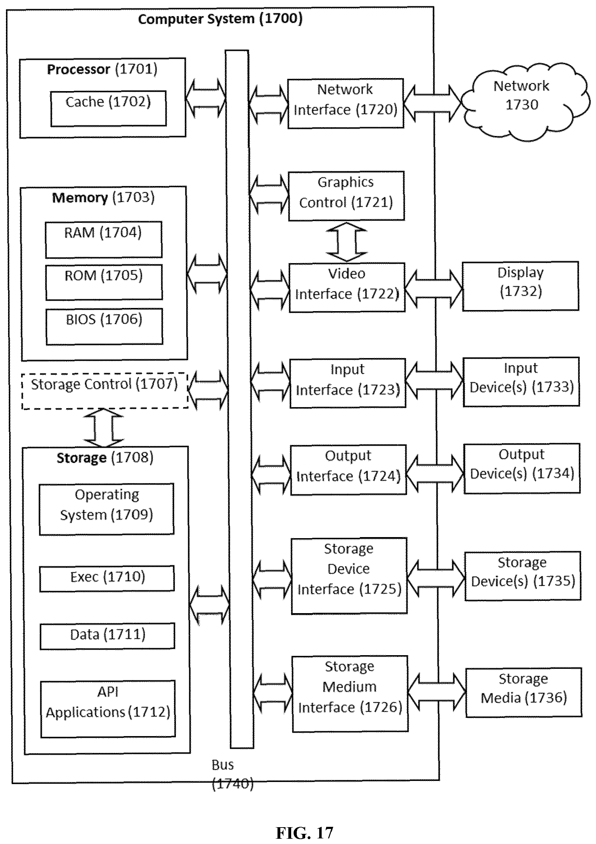

Referring to FIG. 17, a block diagram is shown depicting an exemplary machine that includes a computer system 1700 (e.g., a processing or computing system) within which a set of instructions can execute for causing a device to perform or execute any one or more of the aspects and/or methodologies for static code scheduling of the present disclosure. The components in FIG. 17 are examples only and do not limit the scope of use or functionality of any hardware, software, embedded logic component, or a combination of two or more such components implementing particular embodiments.

Computer system 1700 may include one or more processors 1701, a memory 1703, and a storage 1708 that communicate with each other, and with other components, via a bus 1740. The bus 1740 may also link a display 1732, one or more input devices 1733 (which may, for example, include a keypad, a keyboard, a mouse, a stylus, etc.), one or more output devices 1734, one or more storage devices 1735, and various tangible storage media 1736. All of these elements may interface directly or via one or more interfaces or adaptors to the bus 1740. For instance, the various tangible storage media 1736 can interface with the bus 1740 via storage medium interface 1726. Computer system 1700 may have any suitable physical form, including but not limited to one or more integrated circuits (ICs), printed circuit boards (PCBs), mobile handheld devices (such as mobile telephones or PDAs), laptop or notebook computers, distributed computer systems, computing grids, or servers.

Computer system 1700 includes one or more processor(s) 1701 (e.g., central processing units (CPUs) or general purpose graphics processing units (GPGPUs)) that carry out functions. Processor(s) 1701 optionally contains a cache memory unit 1702 for temporary local storage of instructions, data, or computer addresses. Processor(s) 1701 are configured to assist in execution of computer readable instructions. Computer system 1700 may provide functionality for the components depicted in FIG. 17 as a result of the processor(s) 1701 executing non-transitory, processor-executable instructions embodied in one or more tangible computer-readable storage media, such as memory 1703, storage 1708, storage devices 1735, and/or storage medium 1736. The computer-readable media may store software that implements particular embodiments, and processor(s) 1701 may execute the software. Memory 1703 may read the software from one or more other computer-readable media (such as mass storage device(s) 1735, 1736) or from one or more other sources through a suitable interface, such as network interface 1720. The software may cause processor(s) 1701 to carry out one or more processes or one or more steps of one or more processes described or illustrated herein. Carrying out such processes or steps may include defining data structures stored in memory 1703 and modifying the data structures as directed by the software.

The memory 1703 may include various components (e.g., machine readable media) including, but not limited to, a random access memory component (e.g., RAM 1704) (e.g., static RAM (SRAM), dynamic RAM (DRAM), ferroelectric random access memory (FRAM), phase-change random access memory (PRAM), etc.), a read-only memory component (e.g., ROM 1705), and any combinations thereof. ROM 1705 may act to communicate data and instructions unidirectionally to processor(s) 1701, and RAM 1704 may act to communicate data and instructions bidirectionally with processor(s) 1701. ROM 1705 and RAM 1704 may include any suitable tangible computer-readable media described below. In one example, a basic input/output system 1706 (BIOS), including basic routines that help to transfer information between elements within computer system 1700, such as during start-up, may be stored in the memory 1703.

Fixed storage 1708 is connected bidirectionally to processor(s) 1701, optionally through storage control unit 1707. Fixed storage 1708 provides additional data storage capacity and may also include any suitable tangible computer-readable media described herein. Storage 1708 may be used to store operating system 1709, executable(s) 1710, data 1711, applications 1712 (application programs), and the like. Storage 1708 can also include an optical disk drive, a solid-state memory device (e.g., flash-based systems), or a combination of any of the above. Information in storage 1708 may, in appropriate cases, be incorporated as virtual memory in memory 1703.

In one example, storage device(s) 1735 may be removably interfaced with computer system 1700 (e.g., via an external port connector (not shown)) via a storage device interface 1725. Particularly, storage device(s) 1735 and an associated machine-readable medium may provide non-volatile and/or volatile storage of machine-readable instructions, data structures, program modules, and/or other data for the computer system 1700. In one example, software may reside, completely or partially, within a machine-readable medium on storage device(s) 1735. In another example, software may reside, completely or partially, within processor(s) 1701.

Bus 1740 connects a wide variety of subsystems. Herein, reference to a bus may encompass one or more digital signal lines serving a common function, where appropriate. Bus 1740 may be any of several types of bus structures including, but not limited to, a memory bus, a memory controller, a peripheral bus, a local bus, and any combinations thereof, using any of a variety of bus architectures. As an example and not by way of limitation, such architectures include an Industry Standard Architecture (ISA) bus, an Enhanced ISA (EISA) bus, a Micro Channel Architecture (MCA) bus, a Video Electronics Standards Association local bus (VLB), a Peripheral Component Interconnect (PCI) bus, a PCI-Express (PCI-X) bus, an Accelerated Graphics Port (AGP) bus, HyperTransport (HTX) bus, serial advanced technology attachment (SATA) bus, and any combinations thereof.

Computer system 1700 may also include an input device 1733. In one example, a user of computer system 1700 may enter commands and/or other information into computer system 1700 via input device(s) 1733. Examples of an input device(s) 1733 include, but are not limited to, an alphanumeric input device (e.g., a keyboard), a pointing device (e.g., a mouse or touchpad), a touchpad, a touch screen, a multi-touch screen, a joystick, a stylus, a gamepad, an audio input device (e.g., a microphone, a voice response system, etc.), an optical scanner, a video or still image capture device (e.g., a camera), and any combinations thereof. In some embodiments, the input device is a Kinect®, Leap Motion®, or the like. Input device(s) 1733 may be interfaced to bus 1740 via any of a variety of input interfaces 1723 (e.g., input interface 1723) including, but not limited to, serial, parallel, game port, USB, FIREWIRE, THUNDERBOLT, or any combination of the above.

In particular embodiments, when computer system 1700 is connected to network 1730, computer system 1700 may communicate with other devices, specifically mobile devices and enterprise systems, distributed computing systems, cloud storage systems, cloud computing systems, and the like, connected to network 1730. Communications to and from computer system 1700 may be sent through network interface 1720. For example, network interface 1720 may receive incoming communications (such as requests or responses from other devices) in the form of one or more packets (such as Internet Protocol (IP) packets) from network 1730, and computer system 1700 may store the incoming communications in memory 1703 for processing. Computer system 1700 may similarly store outgoing communications (such as requests or responses to other devices) in the form of one or more packets in memory 1703 and communicated to network 1730 from network interface 1720. Processor(s) 1701 may access these communication packets stored in memory 1703 for processing.

Examples of the network interface 1720 include, but are not limited to, a network interface card, a modem, and any combination thereof. Examples of a network 1730 or network segment 1730 include, but are not limited to, a distributed computing system, a cloud computing system, a wide area network (WAN) (e.g., the Internet, an enterprise network), a local area network (LAN) (e.g., a network associated with an office, a building, a campus or other relatively small geographic space), a telephone network, a direct connection between two computing devices, a peer-to-peer network, and any combinations thereof. A network, such as network 1730, may employ a wired and/or a wireless mode of communication. In general, any network topology may be used.

Information and data can be displayed through a display 1732. Examples of a display 1732 include, but are not limited to, a cathode ray tube (CRT), a liquid crystal display (LCD), a thin film transistor liquid crystal display (TFT-LCD), an organic liquid crystal display (OLED) such as a passive-matrix OLED (PMOLED) or active-matrix OLED (AMOLED) display, a plasma display, and any combinations thereof. The display 1732 can interface to the processor(s) 1701, memory 1703, and fixed storage 1708, as well as other devices, such as input device(s) 1733, via the bus 1740. The display 1732 is linked to the bus 1740 via a video interface 1722, and transport of data between the display 1732 and the bus 1740 can be controlled via the graphics control 1721. In some embodiments, the display is a video projector. In some embodiments, the display is a head-mounted display (HMD) such as a VR headset. In further embodiments, suitable VR headsets include, by way of non-limiting examples, HTC Vive®, Oculus Rift®, Samsung Gear VR®, Microsoft HoloLens®, Razer OSVR®, FOVE VR®, Zeiss VR One®, Avegant Glyph®, Freefly VR® headset, and the like. In still further embodiments, the display is a combination of devices such as those disclosed herein.

In addition to a display 1732, computer system 1700 may include one or more other peripheral output devices 1734 including, but not limited to, an audio speaker, a printer, a storage device, and any combinations thereof. Such peripheral output devices may be connected to the bus 1740 via an output interface 1724. Examples of an output interface 1724 include, but are not limited to, a serial port, a parallel connection, a USB port, a FIREWIRE port, a THUNDERBOLT port, and any combinations thereof.

In addition or as an alternative, computer system 1700 may provide functionality as a result of logic hardwired or otherwise embodied in a circuit, which may operate in place of or together with software to execute one or more processes or one or more steps of one or more processes described or illustrated herein. Reference to software in this disclosure may encompass logic, and reference to logic may encompass software. Moreover, reference to a computer-readable medium may encompass a circuit (such as an IC) storing software for execution, a circuit embodying logic for execution, or both, where appropriate. The present disclosure encompasses any suitable combination of hardware, software, or both.

Various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by one or more processor(s), or in a combination of the two. A software module may reside in RAM memory, flash memory, ROM memory, EPROM memory, EEPROM memory, registers, hard disk, a removable disk, a CD-ROM, or any other form of storage medium. An exemplary storage medium is coupled to the processor such the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

In accordance with the description herein, suitable computing devices include, by way of non-limiting examples, server computers, desktop computers, laptop computers, notebook computers, subnotebook computers, netbook computers, netpad computers, set-top computers, media streaming devices, handheld computers, Internet appliances, mobile smartphones, tablet computers, personal digital assistants, video game consoles, and vehicles. Select televisions, video players, and digital music players with optional computer network connectivity are suitable for use in the system described herein. Suitable tablet computers, in various embodiments, include those with booklet, slate, and convertible configurations.

In some embodiments, the computing device includes an operating system configured to perform executable instructions. The operating system is, for example, software, including programs and data, which manages the device's hardware and provides services for execution of applications. Suitable server operating systems include, by way of non-limiting examples, FreeBSD®, OpenBSD®, NetBSD®, Linux®, Apple® Mac OS X Server®, Oracle Solaris®, Windows Server®, and Novell NetWare®. Suitable personal computer operating systems include, by way of non-limiting examples, Microsoft Windows®, Apple Mac® OS X, UNIX®, and UNIX-like operating systems such as GNU/Linux®. In some embodiments, the operating system is provided by cloud computing. Suitable mobile smartphone operating systems include, by way of non-limiting examples, Nokia Symbian® OS, Apple® iOS, Research In Motion BlackBerry® OS, Google® Android®, Microsoft® Windows Phone® OS, Microsoft® Windows Mobile OS, Linux®, and Palm® WebOS. Suitable media streaming device operating systems include, by way of non-limiting examples, Apple TV®, Roku®, Boxee®, Google TV®, Google Chromecast®, Amazon Fire®, and Samsung® HomeSync®. Suitable video game console operating systems include, by way of non-limiting examples, Sony® PS3®, Sony® PS4®, Microsoft® Xbox 360®, Microsoft Xbox One®, Nintendo Wii®, Nintendo Wii U®, and Ouya®. Suitable virtual reality headset systems include, by way of non-limiting example, Meta Oculus®.

### Non-transitory computer readable storage mediums

In some embodiments, the platforms, systems, media, and methods disclosed herein include one or more non-transitory computer readable storage media encoded with a program including instructions executable by the operating system of an optionally networked computing device. In further embodiments, a computer readable storage medium is a tangible component of a computing device. In still further embodiments, a computer readable storage medium is optionally removable from a computing device. In some embodiments, a computer readable storage medium includes, by way of non-limiting examples, CD-ROMs, DVDs, flash memory devices, solid state memory, magnetic disk drives, magnetic tape drives, optical disk drives, distributed computing systems including cloud computing systems and services, and the like. In some cases, the program and instructions are permanently, substantially permanently, semi-permanently, or non-transitorily encoded on the media.

### Computer programs

In some embodiments, the platforms, systems, media, and methods disclosed herein include at least one computer program, or use of the same. A computer program includes a sequence of instructions, executable by one or more processor(s) of the computing device's CPU, written to perform a specified task. Computer readable instructions may be implemented as program modules, such as functions, objects, Application Programming Interfaces (APIs), computing data structures, and the like, that perform particular tasks or implement particular abstract data types. In light of the disclosure provided herein, a computer program may be written in various versions of various languages.

The functionality of the computer readable instructions may be combined or distributed as desired in various environments. In some embodiments, a computer program comprises one sequence of instructions. In some embodiments, a computer program comprises a plurality of sequences of instructions. In some embodiments, a computer program is provided from one location. In other embodiments, a computer program is provided from a plurality of locations. In various embodiments, a computer program includes one or more software modules. In various embodiments, a computer program includes, in part or in whole, one or more web applications, one or more mobile applications, one or more standalone applications, one or more web browser plug-ins, extensions, add-ins, or add-ons, or combinations thereof.

### Web applications

In some embodiments, a computer program includes a web application. In light of the disclosure provided herein, a web application, in various embodiments, utilizes one or more software frameworks and one or more database systems. In some embodiments, a web application is created upon a software framework such as Microsoft® .NET or Ruby on Rails® (RoR). In some embodiments, a web application utilizes one or more database systems including, by way of non-limiting examples, relational, non-relational, object oriented, associative, and XML database systems. In further embodiments, suitable relational database systems include, by way of non-limiting examples, Microsoft® structured query language (SQL) Server, mySQL™, and Oracle®. A web application, in various embodiments, is written in one or more versions of one or more languages. A web application may be written in one or more markup languages, presentation definition languages, client-side scripting languages, server-side coding languages, database query languages, or combinations thereof. In some embodiments, a web application is written to some extent in a markup language such as Hypertext Markup Language (HTML), Extensible Hypertext Markup Language (XHTML), or eXtensible Markup Language (XML). In some embodiments, a web application is written to some extent in a presentation definition language such as Cascading Style Sheets (CSS). In some embodiments, a web application is written to some extent in a client-side scripting language such as Asynchronous Javascript and XML® (AJAX), Flash Actionscript, Javascript®, or Silverlight®. In some embodiments, a web application is written to some extent in a server-side coding language such as Active Server Pages® (ASP), ColdFusion®, Perl®, Java®, JavaServer Pages® (JSP), Hypertext Preprocessor® (PHP), Python®, Ruby®, Tcl®, Smalltalk®, WebDNA®, or Groovy®. In some embodiments, a web application is written to some extent in a database query language such as Structured Query Language (SQL). In some embodiments, a web application integrates enterprise server products such as IBM Lotus Domino®. In some embodiments, a web application includes a media player element. In various further embodiments, a media player element utilizes one or more of many suitable multimedia technologies including, by way of non-limiting examples, Adobe® Flash®, HTML 5, Apple® QuickTime®, Microsoft Silverlight®, Java®, and Unity®.

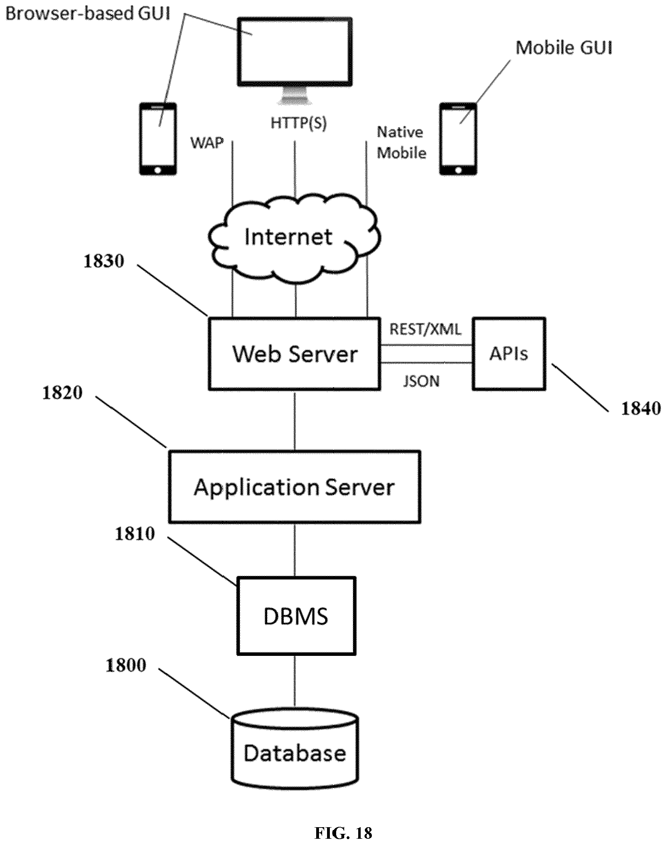

Referring to FIG. 18, in a particular embodiment, an application provision system comprises one or more databases 1800 accessed by a database management system (DBMS) 1810. Suitable DBMSs include Firebird®, MySQL®, NoSQL®, PostgreSQL®, SQLite®, Oracle Database®, Microsoft SQL Server®, IBM DB2®, IBM Informix®, SAP Sybase®, SAP Sybase®, Teradata®, PostGIS®, Apache® Hive, Apache® Impala, time-series databases, graph databases, key-value storage, and the like. In this embodiment, the application provision system further comprises one or more application severs 1820 (such as Java® servers, .NET® servers, PHP® servers, and the like) and one or more web servers 1830 (such as Apache®, IIS®, GWS® and the like). The web server(s) optionally expose one or more web services via app application programming interfaces (APIs) 1840. Via a network, such as the Internet, the system provides browser-based and/or mobile native user interfaces. In some cases, a DBMS may be a relational DBMS.

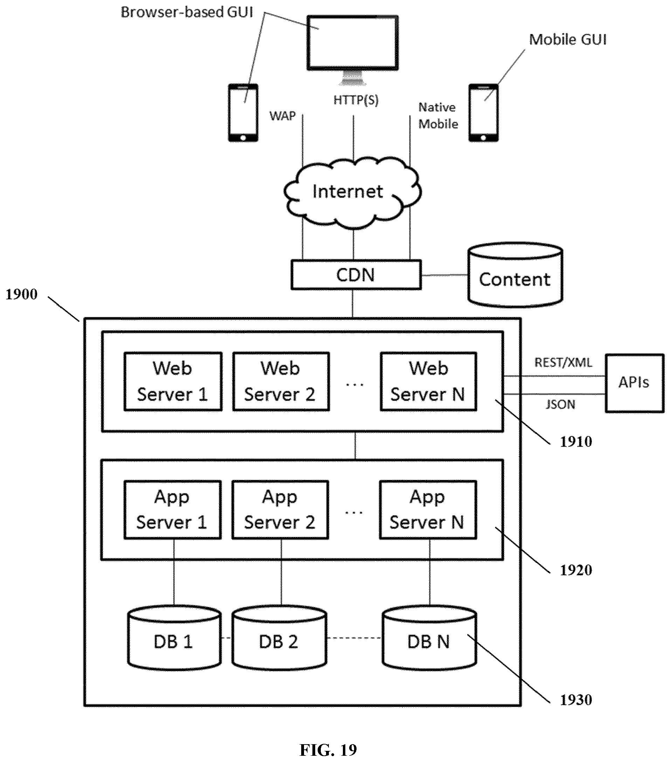

Referring to FIG. 19, in a particular embodiment, an application provision system alternatively has a distributed, cloud-based architecture 1900 and comprises elastically load balanced, auto-scaling web server resources 1910 and application server resources 1920 as well synchronously replicated databases 1930.

### *Mobile applications*

In some embodiments, a computer program includes a mobile application provided to a mobile computing device. In some embodiments, the mobile application is provided to a mobile computing device at the time it is manufactured. In other embodiments, the mobile application is provided to a mobile computing device via the computer network described herein.

In view of the disclosure provided herein, a mobile application is created by techniques using hardware, languages, and development environments. Mobile applications are written in several languages. Suitable programming languages include, by way of non-limiting examples, C, C++, C#, Objective-C, Java®, Javascript®, Pascal®, Object Pascal®, Python™, Ruby®, VB.NET®, WML®, and XHTML/HTML with or without CSS, or combinations thereof.

Suitable mobile application development environments are available from several sources. Commercially available development environments include, by way of non-limiting examples, AirplaySDK®, alcheMo®, Appcelerator®, Celsius®, Bedrock®, Flash Lite®, .NET Compact Framework®, Rhomobile®, and WorkLight Mobile Platform®. Other development environments are available without cost including, by way of non-limiting examples, Lazarus®, MobiFlex®, MoSync®, and Phonegap®. Also, mobile device manufacturers distribute software developer kits including, by way of non-limiting examples, iPhone® and iPad® (iOS) SDK, Android® SDK, BlackBerry® SDK, BREW SDK, Palm® OS SDK, Symbian® SDK, webOS® SDK, and Windows® Mobile SDK.

Several commercial sources are available for distribution of mobile applications including, by way of non-limiting examples, Apple® App Store, Google® Play, Chrome® WebStore, BlackBerry® App World, App Store® for Palm devices, App Catalog® for webOS, Windows® Marketplace for Mobile, Ovi Store for Nokia® devices, Samsung® Apps, and Nintendo® DSi Shop.

### *Standalone applications*

In some embodiments, a computer program includes a standalone application, which is a program that is run as an independent computer process, not an add-on to an existing process, e.g., not a plug-in. Standalone applications are often compiled. A compiler is a computer program(s) that transforms source code written in a programming language into binary object code such as assembly language or machine code. Suitable compiled programming languages include, by way of non-limiting examples, C, C++, Objective-C®, COBOL®, Delphi®, Eiffel®, Java®, Lisp®, Python®, Visual Basic®, and VB .NET®, or combinations thereof. Compilation is often performed, at least in part, to create an executable program.

In some embodiments, a computer program includes one or more executable compiled applications. Additionally, microservices related to Python® and JavaScript® may be used.

### Web browser plug-ins

In some embodiments, the computer program includes a web browser plug-in (e.g., web extension, etc.). In computing, a plug-in is one or more software components that add specific functionality to a larger software application. Makers of software applications support plug-ins to enable third-party developers to create abilities which extend an application, to support easily adding new features, and to reduce the size of an application. When supported, plug-ins enable customizing the functionality of a software application. For example, plug-ins are commonly used in web browsers to play video, generate interactivity, scan for viruses, and display particular file types. Several web browser plug-ins may include Adobe Flash Player®, Microsoft Silverlight®, and Apple QuickTime®. In some embodiments, the toolbar comprises one or more web browser extensions, add-ins, or add-ons. In some embodiments, the toolbar comprises one or more explorer bars, tool bands, or desk bands.

In view of the disclosure provided herein, several plug-in frameworks are available that enable development of plug-ins in various programming languages, including, by way of non-limiting examples, C++, Delphi®, Java®, PHP®, Python®, and VB .NET®, or combinations thereof.

Web browsers (also called Internet browsers) are software applications, designed for use with network-connected computing devices, for retrieving, presenting, and traversing information resources on the World Wide Web. Suitable web browsers include, by way of non-limiting examples, Microsoft Internet Explorer®, Mozilla Firefox®, Google Chrome®, Apple Safari®, Opera Software Opera®, and KDE Konqueror®. In some embodiments, the web browser is a mobile web browser. Mobile web browsers (also called microbrowsers, mini-browsers, and wireless browsers) are designed for use on mobile computing devices including, by way of non-limiting examples, handheld computers, tablet computers, netbook computers, subnotebook computers, smartphones, music players, personal digital assistants (PDAs), and handheld video game systems. Suitable mobile web browsers include, by way of non-limiting examples, Google Android® browser, RIM BlackBerry® Browser, Apple Safari®, Palm Blazer®, Palm WebOS® Browser, Mozilla Firefox® for mobile, Microsoft Internet Explorer Mobile®, Amazon Kindle Basic Web®, Nokia Browser®, Opera Software Opera Mobile®, and Sony PSP® browser.

### Software modules

In some embodiments, the platforms, systems, media, and methods disclosed herein include software, server, and/or database modules, or use of the same. In view of the disclosure provided herein, software modules are created by techniques using machines, software, and languages. The software modules disclosed herein are implemented in a multitude of ways. In various embodiments, a software module comprises a file, a section of code, a programming object, a programming structure, or combinations thereof. In further various embodiments, a software module comprises a plurality of files, a plurality of sections of code, a plurality of programming objects, a plurality of programming structures, or combinations thereof. In various embodiments, the one or more software modules comprise, by way of non-limiting examples, a web application, a mobile application, and a standalone application. In some embodiments, software modules are in one computer program or application. In other embodiments, software modules are in more than one computer program or application. In some embodiments, software modules are hosted on one machine. In other embodiments, software modules are hosted on more than one machine. In further embodiments, software modules are hosted on a distributed computing platform such as a cloud computing platform. In some embodiments, software modules are hosted on one or more machines in one location. In other embodiments, software modules are hosted on one or more machines in more than one location.

### Databases

In some embodiments, the platforms, systems, media, and methods disclosed herein include one or more databases (DB), or use of the same. In view of the disclosure provided herein, many databases are suitable for storage and retrieval data. In various embodiments, suitable databases include, by way of non-limiting examples, relational databases, non-relational databases, object oriented databases, object databases, entity-relationship model databases, associative databases, XML databases, time-series databases, graph databases, and the like. Further non-limiting examples include SQL, PostgreSQL®, MySQL®, Oracle®, DB2®, and Sybase. In some embodiments, a database is internet-based. In further embodiments, a database is web-based. In still further embodiments, a database is cloud computing-based. In a particular embodiment, a database is a distributed database. In other embodiments, a database is based on one or more local computer storage devices.

**Terms and Definitions**

Unless otherwise defined, all technical terms used herein have the same meaning as commonly understood by one of ordinary skill in the art to which this disclosure belongs.

As used herein, the singular forms "a," "an," and "the" include plural references unless the context clearly dictates otherwise. Any reference to "or" herein is intended to encompass "and/or" unless otherwise stated.

As used herein, the term "about" in some cases refers to an amount that is approximately the stated amount.

As used herein, the term "about" refers to an amount that is near the stated amount by 10%, 5%, or 1%, including increments therein.

As used herein, the term "about" in reference to a percentage refers to an amount that is greater or less the stated percentage by 10%, 5%, or 1%, including increments therein.

As used herein, the phrases "at least one", "one or more", and "and/or" are open-ended expressions that are both conjunctive and disjunctive in operation. For example, each of the expressions "at least one of A, B and C", "at least one of A, B, or C", "one or more of A, B, and C", "one or more of A, B, or C" and "A, B, and/or C" means A alone, B alone, C alone, A and B together, A and C together, B and C together, or A, B and C together.

While preferred embodiments of the present disclosure have been shown and described herein, such embodiments are provided by way of example only. It is not intended that the disclosure be limited by the specific examples provided within the specification. While the disclosure has been described with reference to the aforementioned specification, the descriptions and illustrations of the embodiments herein are not meant to be construed in a limiting sense. Numerous variations, changes, and substitutions may occur without departing from the disclosure. Furthermore, it shall be understood that all aspects of the disclosure are not limited to the specific depictions, configurations or relative proportions set forth herein which depend upon a variety of conditions and variables. It should be understood that various alternatives to the embodiments of the disclosure described herein may be employed in practicing the disclosure. It is therefore contemplated that the disclosure shall also cover any such alternatives, modifications, variations, or equivalents. It is intended that the following claims define the scope of the disclosure and that methods and structures within the scope of these claims and their equivalents be covered thereby.

**Claims**

1.   A system for process monitoring and control, comprising:

   a data processing module configured to receive and process a plurality of data types and datasets from a plurality of different sources for generating training data;
   a training and optimization module configured to provide the training data to a machine learning pipeline for training and optimizing a model; and
   an inference module configured to use the model for generating one or more predicted metrics substantially in real-time, wherein the one or more predicted metrics are useable to characterize an output of a process performed by a process equipment.

2.   The system of claim 1, wherein the inference module is configured to receive and provide process data to the model for generating the one or more predicted metrics, wherein the process data is received from the process equipment substantially in real-time as the process is performed.

3.   The system of claim 1, wherein the inference module is configured to provide the one or more predicted metrics for the process control, or for process monitoring, improvement or trouble-shooting.

4.   The system of claim 1, further comprising a process control module configured to use the one or more predicted metrics to detect a drift, a shift, or a deviation in the process or the process equipment.

5.   The system of claim 4, wherein the process control module is configured to use the one or more predicted metrics to correct or mitigate the drift, the shift, or the deviation in the process or the process equipment.

6.   The system of claim 4, wherein the process control module is configured to use the one or more predicted metrics to improve process productivity via integration with run-to-run control.

7.   The system of claim 1, wherein the model comprises a virtual metrology (VM) model.

8. The system of claim 1, further comprising the process equipment, wherein said process equipment comprises a semiconductor process equipment.

9. The system of claim 1, wherein the output of the process comprises a deposited or fabricated structure.

10. The system of claim 9, wherein the deposited or fabricated structure comprises a film, a layer, or a substrate.

11. The system of claim 10, wherein the one or more predicted metrics comprise one or more dimensions or properties of the film, the layer, or the substrate.

12. The system of claim 1, wherein the system is configured to be used or deployed in a manufacturing environment.

13. The system of claim 1, wherein the plurality of data types and datasets comprise: (1) historical process data, (2) current process data, (3) historical measurement data of the one or more predicted metrics, (4) current measurement data of the one or more predicted metrics, (5) operation data, and/or (6) equipment specification data.

14. The system of claim 13, wherein the data processing module is configured to validate the historical process data and the historical measurement data against the operation data and the equipment specification data.

15. The system of claim 13, wherein the plurality of sources comprise a database that is configured to store at least the historical process data or the historical measurement data.

16. The system of claim 13, wherein the plurality of sources comprise a database or a log that is configured to store at least the operation data or the equipment specification data.

17. The system of claim 13, wherein the plurality of sources comprise the process equipment.

18. The system of claim 13, wherein the plurality of sources comprise a measurement equipment configured to collect the current measurement data.

19. The system of claim 1, wherein the data processing module is configured to receive and process the plurality of data types or datasets by generating a component hierarchical structure of the process equipment.

20. The system of claim 19, wherein the component hierarchical structure comprises a nested structure of (i) the process equipment and (ii) one or more components that are used within or in conjunction with the process equipment.

21. The system of claim 20, wherein the one or more components comprise one or more sub-equipment including chambers, stations, and/or sensors.

22. The system of claim 1, wherein the data processing module is configured to receive and process the plurality of data types or datasets by generating a step-operation hierarchical structure of a recipe for the process.

23. The system of claim 22, wherein the recipe comprises a plurality of steps, and wherein each step of the plurality of steps comprises a plurality of different sub-operations.

24. The system of claim 1, wherein the data processing module is configured to receive and process the plurality of data types or datasets by removing one or more data outliers.

25. The system of claim 2, wherein the data processing module is configured to pre-process and remove data outliers from the process data before the process data is input to the model in the inference module.

26. The system of claim 13, wherein the training data is continuously updated with the current process data and the current measurement data.

27. The system of claim 1, wherein the machine learning pipeline comprises two or more components from a plurality of components comprising of (i) feature engineering, (ii) time-aware data normalization, and/or (iii) an adaptive learning algorithm.

28. The system of claim 27, wherein the machine learning pipeline is configured to apply the training data through the two or more components sequentially or simultaneously.

29. The system of claim 27, wherein the feature engineering comprises an extraction of a plurality of features from raw trace data or sensor data within the training data.

30. The system of claim 27, wherein the feature engineering comprises use of an algorithm to select one or more features from a list of extracted features, based at least in part on local relationships between an input and an output of the model.

31. The system of claim 27, wherein the time-aware data normalization comprises a decomposition of time series data into one or more components including smoothing data, trend data, and/or detrend data.

32. The system of claim 27, wherein the time-aware data normalization is based on a model and a data type of the model.

33. The system of claim 27, wherein the adaptive learning algorithm is an adaptive online ensemble learning algorithm.

34. The system of claim 1, wherein the training and optimization module is configured to optimize the model using at least in part hyperparameter optimization.

35. The system of any of claims 27 to 34, wherein the training and optimization module is configured to (i) train the model with a given set of hyperparameters on an output from the machine learning pipeline.

36. The system of claim 35, wherein the training and optimization module is further configured to (ii) evaluate a performance of the model based on validation data.

37. The system of claim 36, wherein the validation data is split from the training data for the hyperparameter optimization.

38. The system of claim 36, wherein the training and optimization module is further configured to (iii) use a hyperparameter optimization algorithm to select a set of hyperparameters for a next iteration based on past performance, so as to increase or improve the performance of the model.

39. The system of claim 38, wherein the training and optimization module is further configured to repeat (i)-(iii) iteratively until the performance of the model meets termination criteria.

40. A method for process monitoring and control, comprising:

(a) receiving and processing a plurality of data types and datasets from a plurality of different sources for generating training data;
(b) providing the training data to a machine learning pipeline for training and optimizing a model; and
(c) generating one or more predicted metrics substantially in real-time, wherein the one or more predicted metrics are useable to characterize an output of a process performed by a process equipment.

FIG. 1

EP 4 418 055 A1

FIG. 2

24

Chamber A    Chamber B    Chamber C  • • •

Processed Wafers

Processing Equipment

Sampled Wafers

Metrology Equipment

Metrology Results

UCL

LCL

Virtual Metrology Results

UCL

LCL

Metrology Data

Process Sensor Data

Prediction Models

**FIG. 3**

25

**FIG. 4A**

**FIG. 4B**

FIG. 5

**FIG. 6**

**FIG. 7**

**FIG. 8**

**(a)**

y = -0.6x + 132

**(b)**

y = x - 103

y = -2x + 201

y = -4.1x + 932

FIG. 9

Window

at t = $t_0$

| 1 | 2 | 3 | 4 | 5 | 6 | 7 | 8 | 9 | 10 |

Window →

at t = $t_0+1$

| 1 | 2 | 3 | 4 | 5 | 6 | 7 | 8 | 9 | 10 |

Window →

at t = $t_0+2$

| 1 | 2 | 3 | 4 | 5 | 6 | 7 | 8 | 9 | 10 |

**FIG. 10**

**FIG. 11A**

**FIG. 11B**

**FIG. 11C**

**FIG. 11D**

---

**Algorithm 1** Follow-the-leading-history [6]

---

**Input:** experts $E$, decay parameter $\eta > 0$

1: Set $w_1^{(1)} = 1$

2: **for** $t = 1, \ldots, T$ **do**

3:   **Inference when observing** $x_t$

   a: Initialize $E^{(t)}$, new instance of algorithm $E$

   b: Predict $\hat{y}_t^{(i)} = E^{(j)}(x_t)$ for $i = 1, \ldots, t$

   c: Compute $\hat{y}_t = \sum_{j=1}^{t} w_t^{(j)} \hat{y}_t^{(j)}$

4:   **Update when observing** $y_t$

   a: Update experts $E^{(i)}$ for $i = 1, \ldots, t$

   b: Update $\hat{w}_{t+1}^{(i)}$ for $i = 1, \ldots, t$

$$\hat{w}_{t+1}^{(i)} = \frac{w_t^{(i)} \exp(-\eta(y_t - \hat{y}_t^{(i)})^2)}{\sum_{j=1}^{t} w_t^{(j)} \exp(-\eta(y_t - \hat{y}_t^{(j)})^2)}$$

   c: Set $w_{t+1}^{(t+1)} = \frac{1}{t+1}$ and update for $i = 1, \ldots, t$

$$w_{t+1}^{(i)} = \left(1 - \frac{1}{t+1}\right) \hat{w}_{t+1}^{(i)}$$

5: **end for**

---

**FIG. 12**

**FIG. 13A**

FIG. 13B

**FIG. 13C**

**FIG. 14A**

**FIG. 14B**

**FIG. 14C**

**FIG. 14D**

FIG. 15

**FIG. 16**

**FIG. 17**

**FIG. 18**

**FIG. 19**

Europäisches Patentamt

European Patent Office

Office européen des brevets

# EUROPEAN SEARCH REPORT

**Application Number**

EP 24 15 6918

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/066411 A1 (UMMETHALA UPENDRA V [US] ET AL) 3 March 2022 (2022-03-03) * paragraphs [0002] - [0078]; figures 1-6 * | 1-40 | INV. G05B13/02 G05B19/418 |
| | ----- | | |
| X | US 2007/005525 A1 (COLLETTE L P III [US] ET AL) 4 January 2007 (2007-01-04) * paragraphs [0046] - [0120]; figures 11A-14B * | 1-40 | |
| | ----- | | |

**TECHNICAL FIELDS SEARCHED (IPC)**

G05B

The present search report has been drawn up for all claims

| Place of search | Date of completion of the search | Examiner |
|---|---|---|
| The Hague | 19 June 2024 | Sollazzo, P |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 6918

This annex lists the patent family members relating to the patent documents cited in the above-mentioned European search report.
The members are as contained in the European Patent Office EDP file on
The European Patent Office is in no way liable for these particulars which are merely given for the purpose of information.

19-06-2024

| Patent document cited in search report | | Publication date | Patent family member(s) | | Publication date |
|---|---|---|---|---|---|
| US 2022066411 | A1 | 03-03-2022 | CN | 115668239 A | 31-01-2023 |
| | | | EP | 4205048 A1 | 05-07-2023 |
| | | | JP | 2023535126 A | 16-08-2023 |
| | | | KR | 20230005323 A | 09-01-2023 |
| | | | TW | 202225873 A | 01-07-2022 |
| | | | US | 2022066411 A1 | 03-03-2022 |
| | | | WO | 2022047235 A1 | 03-03-2022 |
| US 2007005525 | A1 | 04-01-2007 | CN | 101203818 A | 18-06-2008 |
| | | | EP | 1880258 A1 | 23-01-2008 |
| | | | US | 2007005525 A1 | 04-01-2007 |
| | | | US | 2008300709 A1 | 04-12-2008 |
| | | | WO | 2006124635 A1 | 23-11-2006 |

EPO FORM P0459

For more details about this annex : see Official Journal of the European Patent Office, No. 12/82